# EUROPEAN PATENT APPLICATION

(11) **EP 4 521 659 A1**
(43) Date of publication of application: **12.03.2025**
(21) Application number: 22948829.1
(22) Date of filing: 08.08.2022
(51) Int. Cl.: H04B 10/40

(54) **LASER TRANSMISSION CIRCUIT, LASER TRANSMISSION ASSEMBLY, AND ELECTRONIC MEASUREMENT INSTRUMENT**

(30) Priority: 27.06.2022 CN 202210739100; 27.06.2022 CN 202210738947
(71) Applicant: Shenzhen Micsig Technology Co., Ltd., Shenzhen, Guangdong 518000 (CN)
(72) Inventor: ZHANG, Xingjie, Shenzhen, Guangdong 518000 (CN); WANG, Guanqun, Shenzhen, Guangdong 518000 (CN)
(74) Representative: Osterhoff, Utz
(86) International application number: PCT/CN2022/110875
(87) International publication number: WO 2024/000737

(57) **Abstract**

Disclosed are a laser transmission circuit, a laser transmission component and an electronic measuring instrument. The laser transmission circuit includes: an analog receiving unit, and a digital feedback path. The analog emission unit is configured to convert the accessed input analog signal into an analog laser signal, and emit the analog laser signal. The analog receiving unit is configured to convert the analog laser signal into an analog electrical signal as an output signal of the laser transmission circuit. An input end of the digital feedback path is connected to an output end of the analog receiving unit. An output end of the digital feedback path is connected to a feedback input end of the analog emission unit. The digital feedback path is configured to access the analog electrical signal output by the analog receiving unit, convert the analog electrical signal into a digital signal, and transmit the digital signal. The digital feedback path is further configured to convert the transmitted digital signal into a low-frequency analog signal and output the low-frequency analog signal to a feedback input end of the analog emission unit. The present application can eliminate the error caused by the laser signal to the analog signal during transmission.

## Description

This application claims the priority of the Chinese patent application filed with the Chinese Patent Office on June 27, 2022, with application number 202210738947.7 and entitled "LASER TRANSMISSION CIRCUIT, LASER TRANSMISSION COMPONENT AND ELECTRONIC MEASURING INSTRUMENT", and the priority of the Chinese patent application filed with the Chinese Patent Office on June 27, 2022, with application number 202210739100.0 and entitled "LASER TRANSMISSION CIRCUIT, LASER TRANSMISSION COMPONENT AND ELECTRONIC MEASURING INSTRUMENT", the entire contents of which are incorporated herein by reference.

### TECHNICAL FIELD

The present application relates to the technical field of laser signal transmission, and in particular to a laser transmission circuit, a laser transmission component and an electronic measuring instrument.

### BACKGROUND

At present, laser signal transmission is typically achieved through using laser diodes. However, the transmission of laser signals is highly susceptible to environmental factors or device operating conditions, resulting in instability. Consequently, this instability causes significant errors in the transmission of analog signals.

### SUMMARY

The present application aims at solving the problem of errors caused by laser signals to analog signals during transmission.

The present application provides a laser transmission circuit, including: an analog emission unit, an analog receiving unit, and a digital feedback path.

In an embodiment, the input end of the analog emission unit is configured to access an input analog signal, convert the input analog signal into an analog laser signal, and emit the analog laser signal.

In an embodiment, the analog receiving unit is configured to receive the analog laser signal emitted by the analog emission unit, and convert the analog laser signal into an analog electrical signal as an output signal of the laser transmission circuit.

In an embodiment, an input end of the digital feedback path is connected to an output end of the analog receiving unit, an output end of the digital feedback path is connected to a feedback input end of the analog emission unit.

In an embodiment, the digital feedback path is configured to access the analog electrical signal output by the analog receiving unit, convert the analog electrical signal into a digital signal, and transmit the digital signal.

In an embodiment, the digital feedback path is further configured to convert the transmitted digital signal into a low-frequency analog signal, and output the low-frequency analog signal to a feedback input end of the analog emission unit.

In an embodiment, the analog emission unit includes: a drive feedback module, and a laser emission module.

In an embodiment, an input end of the drive feedback module is connected to the input end of the analog emission unit, and a first feedback input end of the drive feedback module is connected to the output end of the digital feedback path.

In an embodiment, a first end of the laser emission module is connected to an output end of the drive feedback module, and a second end of the laser emission module is configured to access a first preset reference voltage.

In an embodiment, the first end of the laser emission module is connected to a positive output end of the drive feedback module, and the second end of the laser emission module is connected to a negative output end of the drive feedback module.

In an embodiment, the laser emission module includes: a laser emission tube and a first resistor.

In an embodiment, one end of the first resistor is connected to the first end of the laser emission module, and another end of the first resistor is connected to the second end of the laser emission module through the laser emission tube.

In an embodiment, the first end of the laser emission tube is connected to the first end of the laser emission module, and the other end of the laser emission tube is connected to the second end of the laser emission module through the first resistor.

In an embodiment, a connection point between the laser emission tube and the first resistor is end F.

The drive feedback module includes a second feedback input end, and the second feedback input end of the drive feedback module is connected to the end F or the output end of the drive feedback module.

In an embodiment, the drive feedback module includes a first amplifier circuit, a high-frequency feedback path, and a low-frequency feedback path.

In an embodiment, the first input end of the first amplifier circuit is connected to an input end of the drive feedback module, the output end of the first amplifier circuit is connected to the output end of the drive feedback module.

In an embodiment, a first input end of the low-frequency feedback path is connected to the first feedback input end of the drive feedback module.

In an embodiment, an input end of the high-frequency feedback path is connected to the second feedback input end of the drive feedback module.

In an embodiment, an output end of the high-frequency feedback path is connected to a second input end of the first amplifier circuit, and an output end of the low-frequency feedback path is connected to the second input end of the first amplifier circuit.

In an embodiment, the first amplifier circuit includes a first operational amplifier.

In an embodiment, one first input end of the first amplifier circuit is provided, a non-inverting input end or an inverting input end of the first operational amplifier is the first input end of the first amplifier circuit, the inverting input end of the first operational amplifier is the second input end of the first amplifier circuit, and the non-inverting input end or the inverting input end of the first operational amplifier is accessed to the input analog signal of a single-ended signal through a second resistor.

In an embodiment, two first input ends of the first amplifier circuit are provided, the non-inverting input end and the inverting input end of the first operational amplifier are respectively the two first input ends of the first amplifier circuit, the inverting input end of the first operational amplifier is the second input end of the first amplifier circuit, the non-inverting input end is accessed to an input analog signal of a differential signal respectively through a third resistor, the inverting input end of the first operational amplifier is accessed to the input analog signal of the differential signal through a fourth resistor, and the non-inverting input end of the first operational amplifier is further accessed to a second preset reference voltage through a fifth resistor.

In an embodiment, the high-frequency feedback path includes a first capacitor, one end of the first capacitor is connected to the input end of the high-frequency feedback path, and another end of the first capacitor is connected to the output end of the high-frequency feedback path.

In an embodiment, the low-frequency feedback path is further provided with a second input end, and the second input end of the low-frequency feedback path is connected to the second feedback input end of the drive feedback module.

In an embodiment, the low-frequency feedback path includes a two-to-one switch and a sixth resistor.

In an embodiment, a first input end of the two-to-one switch is connected to a first input end of the low-frequency feedback path to access the low-frequency analog signal, a second input end of the two-to-one switch is connected to a second input end of the low-frequency feedback path, one end of the sixth resistor is connected to an output end of the two-to-one-one switch, and the another end of the sixth resistor is connected to the output end of the low-frequency feedback path.

In an embodiment, the analog receiving unit includes: a second amplifier circuit, a laser receiving tube, and a seventh resistor.

In an embodiment, an output end of the second amplifier circuit is connected to the output end of the analog receiving unit.

In an embodiment, a first end of the laser receiving tube is configured to access a third preset reference voltage, a second end of the laser receiving tube is connected to one end of the seventh resistor and a first input end of the second amplifier circuit respectively, another end of the seventh resistor is configured to access a fourth preset reference voltage.

In an embodiment, the first end of the laser receiving tube is configured to access a third preset reference voltage, the second end of the laser receiving tube is connected to one end of the seventh resistor and a first input end of the second amplifier circuit respectively, and another end of the seventh resistor is connected to the output end of the second amplifier circuit, and a second input end of the second amplifier circuit is configured to access the fourth preset reference voltage.

In an embodiment, the first end of the laser receiving tube is configured to access the third preset reference voltage, the second end of the laser receiving tube is connected to one end of the seventh resistor, and another end of the seventh resistor is configured to access the fourth preset reference voltage, the first input end of the second amplifier circuit is connected to one end of the seventh resistor, and the second input end of the second amplifier circuit is connected to another end of the seventh resistor.

In an embodiment, the digital feedback path includes: a first low-pass filter unit, a first processing unit, and a second processing unit.

In an embodiment, an input end of the first low-pass filter unit is connected to the input end of the digital feedback path, the first low-pass filter unit is configured to output the analog electrical signal after low-pass filtering.

In an embodiment, an input end of the first processing unit is connected to an output end of the first low-pass filter unit, the first processing unit is configured to convert the low-pass filtered analog electrical signal into a digital signal and output the digital signal.

In an embodiment, an output end of the second processing unit is connected to an output end of the digital feedback path, the second processing unit is configured to receive the digital signal emitted by the first processing unit, convert the digital signal into a low-frequency analog signal, and output the low-frequency analog signal to the output end of the digital feedback path.

In an embodiment, the first processing unit includes an analog-to-digital conversion module, a first processor, and a digital emission module.

In an embodiment, the second processing unit includes: a digital receiving module, a second processor, and a digital-to-analog conversion module.

In an embodiment, an input end of the analog-to-digital conversion module is connected to the input end of the first processing unit, an output end of the analog-to-digital conversion module is connected to an input end of the first processor, an output end of the first processor is connected to the input end of the digital emission module, and the digital emission module is configured to emit the digital signals.

In an embodiment, the digital receiving module is configured to receive the digital signal emitted by the digital emission module, an output end of the digital receiving module is connected to an input end of the second processor, an output end of the second processor is connected to an input end of the digital-to-analog conversion module, and an output end of the digital-to-analog conversion module is connected to the output end of the second processing unit.

In an embodiment, the digital emission module is a laser transmitting tube, and the digital receiving module is a laser receiving tube.

In an embodiment, the digital emission module is a wireless transmitting circuit, and the digital receiving module is a wireless receiving circuit.

In an embodiment, the digital emission module is an opto-coupler unit, and the digital receiving module is a main controller.

In an embodiment, the digital emission module is the main controller, and the digital receiving module is the opto-coupler unit.

In an embodiment, the digital feedback path further includes a second low-pass filter unit, an input end of the second low-pass filter unit is connected to the output end of the second processing unit, and an output end of the second low-pass filter unit is connected to the output end of the digital feedback path.

In an embodiment, the second low-pass filter unit is configured to low-pass filter and output the low-frequency analog signal output by the second processing unit to the analog emission unit.

The present application provides a laser transmission circuit. The laser transmission circuit includes: an analog emission unit, a digital emission unit, and a receiving unit.

In an embodiment, an input end of the analog emission unit is configured to access an input analog signal of the laser transmission circuit, and emit an analog laser signal corresponding to the input analog signal.

In an embodiment, an input end of the digital emission unit is configured to access the input analog signal of the laser transmission circuit, and emit a digital signal corresponding to a low-frequency component of the input analog signal.

In an embodiment, the receiving unit is configured to receive the analog laser signal output by the analog emission unit and the digital signal output by the digital emission unit, and generate an analog electrical signal corresponding to the analog laser signal and a digital electrical signal corresponding to the digital signal.

In an embodiment, the receiving unit is further configured to correct the generated analog electrical signal according to the generated digital electrical signal, and output the corrected analog electrical signal.

In an embodiment, the analog emission unit includes: a drive module, and a laser emission module.

In an embodiment, an input end of the drive module is connected to an input end of the analog emission unit.

In an embodiment, a first end of the laser emission module is connected to an output end of the drive module, and a second end of the laser emission module is configured to access a first preset voltage.

In an embodiment, the first end of the laser emission module is connected to a positive output end of the drive module, and the second end of the laser emission module is connected to a negative output end of the drive module to access a differential signal output by the drive module.

In an embodiment, the laser emission module includes: a laser emission tube, and a first resistor.

In an embodiment, one end of the first resistor is connected to the first end of the laser emission module, and another end of the first resistor is connected to the second end of the laser emission module through the laser emission tube.

In an embodiment, the first end of the laser emission tube is connected to the first end of the laser emission module, and the other end of the laser emission tube is connected to the second end of the laser emission module through the first resistor.

In an embodiment, when in response to that the first end of the laser emission tube is connected to the first end of the laser emission module and another end of the laser emission tube is connected to the second end of the laser emission module through the first resistor, a connection point between the laser emission tube and the first resistor is an end F, the drive module includes a first amplifier circuit, and the first amplifier circuit is provided with a non-inverting input end and an inverting input end.

In an embodiment, the input analog signal is a single-ended signal, the non-inverting input end or the inverting input end of the first amplifier circuit is connected to the input analog signal through a third resistor, a second input end of the first amplifier circuit is further connected to an output end of the first amplifier circuit or the end F through a fourth resistor.

In an embodiment, the input analog signal is a differential signal, the non-inverting input end of the first amplifier circuit is accessed to the input analog signal through a fifth resistor, the inverting input end of the first amplifier circuit is accessed to the input analog signal through a sixth resistor, and the non-inverting input end is accessed to a reference voltage through a seventh resistor.

In an embodiment, the digital emission unit includes: a first low-pass filter unit, a first main control unit, and a digital emission module.

In an embodiment, an input end of the first low-pass filter unit is the input end of the digital emission unit, and an output end of the first low-pass filter unit is connected to a controlled end of the digital emission module through the first main control unit.

In an embodiment, the first main control unit includes a first main controller and a first analog-to-digital conversion module, and the first low-pass filter unit is connected to the controlled end of the digital emission module through the first main controller and the first analog-to-digital conversion module.

In an embodiment, the receiving unit includes: an analog receiving unit configured to receive the analog laser signal and output the analog electrical signal, a digital receiving unit configured to receive the digital signal and output the digital electrical signal, and a signal processing unit.

In an embodiment, a first input end of the signal processing unit is connected to an output end of the analog receiving unit and a second input end of the signal processing unit is connected to an output end of the digital receiving unit, the signal processing unit is configured to perform signal process on the accessed analog electrical signal and the digital electrical signal, and output a low-frequency correction signal to a feedback end of the analog receiving unit.

In an embodiment, the analog receiving unit is further configured to correct a low-frequency operating point according to the received low-frequency correction signal, and output an analog electrical signal corresponding to the corrected low-frequency operating point.

In an embodiment, the analog receiving unit includes: a laser receiving tube, a second resistor and a second amplifier circuit.

In an embodiment, a first electrode of the laser receiving tube is configured to access a second preset voltage, a second electrode of the laser receiving tube is connected to a first input end of the second amplifier circuit, the second electrode of the laser receiving tube the electrode is further connected to a third preset voltage through the second resistor, a second input end of the second amplifier circuit is a feedback end of the analog receiving unit, and an output end of the second amplifier circuit is the output end of the analog receiving unit.

In an embodiment, the first electrode of the laser receiving tube is configured to access a fourth preset voltage, the second electrode of the laser receiving tube is connected to a second input end of the second amplifier circuit, the second electrode of the laser receiving tube is further connected to the output end of the second amplifier circuit through the second resistor, the first input end of the second amplifier circuit is the feedback end of the analog receiving unit, and the output end of the second amplifier circuit is the output end of the analog receiving unit.

In an embodiment, the signal processing unit includes: a second low-pass filter unit, a second main control unit and a comparison circuit.

In an embodiment, an input end of the second low-pass filter unit is the first input end of the signal processing unit, the output end of the second low-pass filter unit is connected to a first input end of the comparison circuit, and an input end of the second main control unit is the second input end of the signal processing unit, an output end of the second main control unit is connected to a second input end of the comparison circuit, and an output end of the comparison circuit is connected to the feedback end of the analog receiving unit.

In an embodiment, the comparison circuit includes a third amplifier circuit, a non-inverting input end of the third amplifier circuit is the first input end of the comparison circuit, and a second input end of the third amplifier circuit is the second input end of the comparison circuit. **In** an embodiment, the second input end of the third amplifier circuit is the first input end of the comparison circuit, and the non-inverting end of the third amplifier circuit is the second input end of the third amplifier circuit.

In an embodiment, the signal processing unit further includes a capacitor circuit connected between the first input end and the output end of the comparison circuit.

In an embodiment, the signal processing unit includes: a third low-pass filter unit, the output end of the comparison circuit is connected to the feedback end of the analog receiving unit through the third low-pass filter unit.

In an embodiment, the second main control unit includes: a second main controller and a first digital-to-analog conversion module, an input end of the second main controller is the input end of the second main control unit, an output end of the second main controller is connected to an input end of the digital-to-analog conversion module, and an output end of the first digital-to-analog conversion module is the output end of the second main control unit.

In an embodiment, the signal processing unit includes: a fourth low-pass filter unit and a third main control unit.

In an embodiment, an input end of the fourth low-pass filter unit is the first input end of the signal processing unit, and an output end of the fourth low-pass filter unit is connected to a first input end of the third main control unit, a second input end of the third main control unit is a second input end of the signal processing unit, and an output end of the third main control unit is an output end of the signal processing unit.

In an embodiment, the third main control unit includes: a second analog-to-digital conversion module, a third main controller, and a second digital-to-analog conversion module.

In an embodiment, the third main controller is connected to the output end of the digital receiving unit, the third main controller is further connected to an output end of the fourth low-pass filter unit through the second analog-to-digital conversion module, and the third main controller is further connected to the feedback end of the analog receiving unit through the second digital-to-analog conversion module.

In an embodiment, the digital emission module is a laser transmitter, and the digital receiving unit is a laser receiver.

In an embodiment, the digital emission module is a wireless transmitting circuit, and the digital receiving unit is a wireless receiving circuit.

In an embodiment, the digital emission module is an opto-coupler unit, and the digital receiving unit is a main controller.

In an embodiment, the digital emission module is the main controller, and the digital receiving unit is the opto-coupler unit.

The present application further provides a laser transmission component including any one of the above-mentioned laser transmission circuits.

The present application further provides an electronic measuring instrument including any one of the above-mentioned laser transmission circuits, or the above-mentioned laser transmission components.

In an embodiment, the electronic measuring instrument is an oscilloscope.

The technical solution of the present application enables the abnormal low-frequency component in the output analog signal to be corrected in real time to a standard low-frequency component that is not affected by the above-mentioned influencing factors. The intermediate-frequency component and the high-frequency component themselves are not affected. Therefore, the corrected output analog signal can be regarded as not being affected by the above-mentioned influencing factors during the laser transmission process. Thereby, linear laser transmission of the analog signal is realized, and the problem that the laser signal causes errors to the analog signal during transmission due to the influence of the above-mentioned influencing factors is solved. In addition, the technical solution of the present application further enables electronic measuring instruments such as oscilloscopes to adopt the solution of laser transmission of analog signals, which overcomes the difficulties of the electronic measurement industry in adopting laser transmission of analog signals, improves the diversity of analog signal transmission, and is further conducive to improving the display accuracy of electronic measuring instruments for analog signals.

### BRIEF DESCRIPTION OF THE DRAWINGS

FIG. 1 is a schematic diagram of a module according to an embodiment of the present application.
FIG. 2 is a module diagram of an analog transmitting circuit according to an embodiment of the present application.
FIG. 3 is a circuit diagram of an analog emission unit according to an embodiment of the present application.
FIG. 4 is a circuit diagram of a drive module feedback according to an embodiment of the present application.
FIG. 5 is a circuit diagram of a high-frequency feedback path according to an embodiment of the present application.
FIG. 6 is a circuit diagram of a low-frequency feedback path according to an embodiment of the present application.
FIG. 7 is a circuit diagram of an analog receiving unit according to an embodiment of the present application.
FIG. 8 is a circuit diagram of an analog receiving unit according to an embodiment of the present application.
FIG. 9 is another module schematic diagram according to an embodiment of the present application.
FIG. 10 is a schematic diagram of a module according to an embodiment of the present application.
FIG. 11 is a schematic diagram of a module of an analog emission unit according to an embodiment of the present application.
FIG. 12 is a circuit diagram of an analog emission unit according to an embodiment of the present application.
FIG. 13 is a circuit diagram of a drive module according to an embodiment of the present application.
FIG. 14 is another module schematic diagram according to an embodiment of the present application.
FIG. 15 is a schematic diagram of four circuits of an analog receiving unit according to an embodiment of the present application.
FIG. 16 is a schematic diagram of three modules of the signal processing unit according to an embodiment of the present application.

### DETAILED DESCRIPTION OF THE EMBODIMENTS

Below is a clear and complete description of the technical solutions in the embodiments of the present application with reference to the drawings in the embodiments of the present application. It is evident that the described embodiments are merely part of the embodiments of the present application, not all of them. Based on the embodiments in the present application, all other embodiments obtained by those skilled in the art without creative efforts shall fall within the scope of protection of the present application.

Additionally, in the present application, the description involving "first", "second", and the like is solely for descriptive purposes and should not be construed as indicating or implying relative importance or implicitly specifying the quantity of technical features indicated. Therefore, features defined as "first" or "second" may explicitly or implicitly include at least one of those features. Furthermore, the technical solutions in various embodiments can be combined with each other, provided that those of ordinary skill in the art can implement them. When a combination of technical solutions results in contradictions or cannot be implemented, it should be considered that such a combination does not exist and is not within the scope of protection required by the present application.

### First embodiment

The present application provides a laser transmission circuit.

In the linear transmission of laser signals, two laser diodes, a laser emission tube D1 and a laser receiving tube D2, are usually required. The laser emission tube D1 can be optically connected to the laser receiving tube D2 directly or through an optical fiber. And the corresponding analog signal in the form of laser can be output according to the accessed analog electrical signal. That is, the analog laser signal is sent to the laser receiving tube D2. However, it is found in actual use that in the overall analog transmission path, for example, factors such as the laser emission tube, the transmission environment, and the laser receiving tube will affect the transmission of the analog signal. As a result, there is an error in the analog laser signal output according to the low-frequency component in the analog electrical signal. This leads to an offset in the low-frequency component of the analog electrical signal restored by the laser receiving tube D2 in the analog receiving unit 20. In this way, for electronic equipment, especially for electronic measuring equipment such as oscilloscopes that have multiple signal transmission links, the offset of the low-frequency component generated in each signal transmission link will be superimposed in sequence. Ultimately, the obtained analog electrical signal has extremely low accuracy. This is precisely the difficulty that the current electronic measurement industry cannot use laser transmission analog signals. It should be noted that, the sources of influence on the laser transmitting tube and the laser receiving tube may include but are not limited to: their own operating temperature and the jitter of the applied instrument. The sources of influence on the transmission environment may include but are not limited to: ambient temperature, ambient light, ambient humidity, and transmission fiber jitter. The above sources of influence are collectively referred to as influencing factors in the following description.

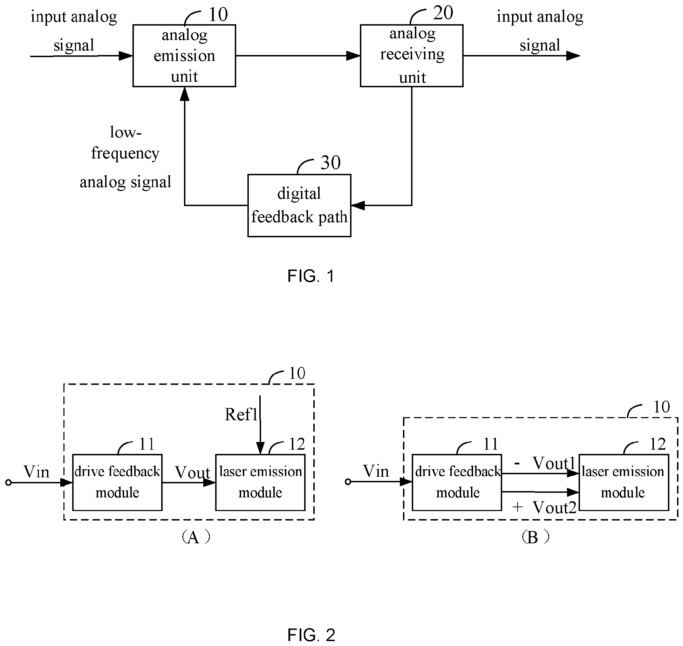

In view of the above problem, as shown in FIG. 1, according to an embodiment of the present application, the laser transmission circuit includes an analog emission unit 10, an analog receiving unit 20, and a digital feedback path 30.

The input end of the analog emission unit 10 is configured to access an input analog signal and, convert the input analog signal into an analog laser signal, and emit the analog laser signal.

The analog receiving unit 20 is configured to receive the analog laser signal emitted by the analog emission unit 10, and convert the analog laser signal into an analog electrical signal as an output signal of the laser transmission circuit.

The input end of the digital feedback path 30 is connected to an output end of the analog receiving unit 20, an output end of the digital feedback path 30 is connected to the feedback input end of the analog emission unit 10.

The digital feedback path 30 is configured to access the analog electrical signal output by the analog receiving unit 20, convert the analog electrical signal into a digital signal, and transmit the digital signal.

The digital feedback path 30 is further configured to convert the transmitted digital signal into a low-frequency analog signal S1, and output the low-frequency analog signal to a feedback input end of the analog emission unit 10.

In an embodiment, the input end of the analog emission unit 10 can be connected to the input end of the laser transmission circuit to access the analog electrical signal to be transmitted, that is, the input analog signal. And according to the input analog signal, the laser transmitting tube D1 can be driven to output an analog signal in the form of a laser, that is, an analog laser signal, for reception by the analog receiving unit 20. It should be noted that the analog laser signal output by the analog emission unit 10 has all the signal components of the input analog signal.

The analog receiving unit 20 can receive an analog laser signal and convert the received analog laser signal into an analog signal of an electrical signal. That is, the analog electrical signal is output as an output signal of the laser transmission circuit, thereby realizing the restored output of the analog laser signal. To simplify the expression, "output analog signal" is used below to represent "output signal of the laser transmission circuit". It can be understood that the output analog signal has three signal components: low-frequency component, intermediate-frequency component and high-frequency component. During the signal transmission process, the low-frequency component in the output analog signal is the low-frequency component that is easily affected by the above-mentioned influencing factors.

The digital feedback path 30 can be divided into a digital filter transmission path and a digital receiving feedback path. The digital filter transmission path can access the output analog signal and separate the low-frequency component therein. And the separated low-frequency component can be transmitted in the form of a digital signal of a corresponding form for reception by the digital receiving feedback path. The digital receiving feedback path can receive the digital signal of the corresponding form transmitted by the digital filter transmission path. And the digital signal of the corresponding form can be converted into an analog electrical signal. That is, the low-frequency analog signal S1 is then output to the feedback input end of the analog emission unit 10. The digital filter transmission path can further transmit all signal components of the output analog signal in the form of a digital signal of a corresponding form. The digital receiving feedback path is configured to convert the digital signal of the corresponding form into an analog electrical signal after receiving the digital signal of the corresponding form transmitted by the digital filter transmission path. And the low-frequency component therein is separated to obtain the low-frequency analog signal S1. It should be noted that the working process of the digital filter transmission path transmitting the corresponding form of the digital signal and the digital receiving feedback path converting the received digital signal into the low-frequency analog signal S1 is not easily affected by the above-mentioned influencing factors. Therefore, the low-frequency analog signal S1 connected to the feedback input end of the analog emission unit 10 can be characterized as a low-frequency component affected by the above-mentioned influencing factors. Since the low-frequency component in the input analog signal is a standard low-frequency component that is not affected by the above-mentioned influencing factors. Therefore, the analog emission unit 10 can use the low-frequency analog signal S1 connected to the feedback input end to adjust the driving electrical signal used to drive the laser transmitting tube in the analog emission unit 10, and enable the laser transmitting tube to emit the corresponding analog laser signal according to the adjusted driving electrical signal, until the abnormal low-frequency component corresponding to the low-frequency analog signal S1 is restored to the standard low-frequency component. That is, the low-frequency component in the output analog signal is restored to the standard low-frequency component.

As such, by repeating the above process, the abnormal low-frequency component in the output analog signal can be corrected in real time to a standard low-frequency component that is not affected by the above-mentioned influencing factors. The intermediate-frequency component and the high-frequency component themselves are not affected. Therefore, the corrected output analog signal can be regarded as not being affected by the above-mentioned influencing factors during the laser transmission process. Thereby, linear laser transmission of the analog signal is realized. And the problem that the laser signal causes errors to the analog signal during transmission due to the influence of the above-mentioned influencing factors is solved. In addition, the technical solution of the present application also enables electronic measuring instruments such as oscilloscopes to adopt the solution of laser transmission of analog signals, which overcomes the difficulties of the electronic measurement industry in adopting laser transmission of analog signals, improves the diversity of analog signal transmission, and is conducive to improving the display accuracy of electronic measuring instruments for analog signals.

As shown in FIG. 2, according to an embodiment of the present application, the analog emission unit 10 includes a drive feedback module 11 and a laser emission module 12.

An input end of the drive feedback module 11 is connected to the input end of the analog emission unit 10. A first feedback input end of the drive feedback module 11 is connected to the output end of the digital feedback path 30.

The first end of the laser emission module 12 is connected to the output end of the drive feedback module 11. A second end of the laser emission module 12 is configured to access a first preset reference voltage Ref1. Or, the first end of the laser emission module 12 is connected to the positive output end of the drive feedback module 11. The second end of the laser emission module 12 is connected to a negative output end of the drive feedback module 11.

In an embodiment, the first feedback input end of the drive feedback module 11 is the feedback input end of the analog emission unit 10. The drive feedback module 11 is configured to perform operational amplification on the input analog signal and then output it to the laser emission module 12, and to drive the laser emission module 12 to emit an analog laser signal. Two driving manners of the drive feedback module 11 to drive the laser emission module 12 are provided here: the first driving manner is specifically shown in FIG. 2 (A). The drive feedback module 11 outputs a single-ended signal (Vout) to the first end of the laser emission module 12. So that the laser emission module 12 can emit a corresponding analog laser signal according to the single-ended signal (Vout) and the first preset reference voltage Ref1 respectively accessed at both ends. The second driving manner is specifically shown in FIG. 2 (B). The drive feedback module 11 outputs a differential signal (Vout1 and Vout2) to both ends of the laser emission module 12. So that the laser emission module 12 can emit a corresponding analog laser signal according to the differential signal (Vout1 and Vout2) accessed at both ends.

The drive feedback can correct the low-frequency operating point according to the received low-frequency analog signal S1, and output the analog electrical signal corresponding to the corrected low-frequency operating point to the laser emission module 12. It should be noted that the low-frequency operating point of the drive feedback module 11 can be changed to adjust the low-frequency offset of the low-frequency component in the output analog signal. Specifically, when the output analog signal is affected by the laser emission tube D1 or the optical fiber jitter, so that the voltage value corresponding to the low-frequency component is greater than the unaffected normal voltage value, the voltage value corresponding to the low-frequency component in the output analog signal can be restored to the normal voltage value by lowering the low-frequency operating point of the drive feedback module 11. When the output analog signal is affected by the laser emission tube D1 or the optical fiber jitter, so that the voltage value corresponding to the low-frequency component in the output analog signal is less than the unaffected normal voltage value, the voltage value corresponding to the low-frequency component in the output analog signal can be restored to the normal voltage value by raising the low-frequency operating point of the drive feedback module 11.

The laser emission module 12 includes: a laser emission tube D1 and a first resistor R1.

One end of the first resistor R1 is connected to the first end of the laser emission module 12, and another end of the first resistor R1 is connected to the second end of the laser emission module 12 through the laser emission tube D1.

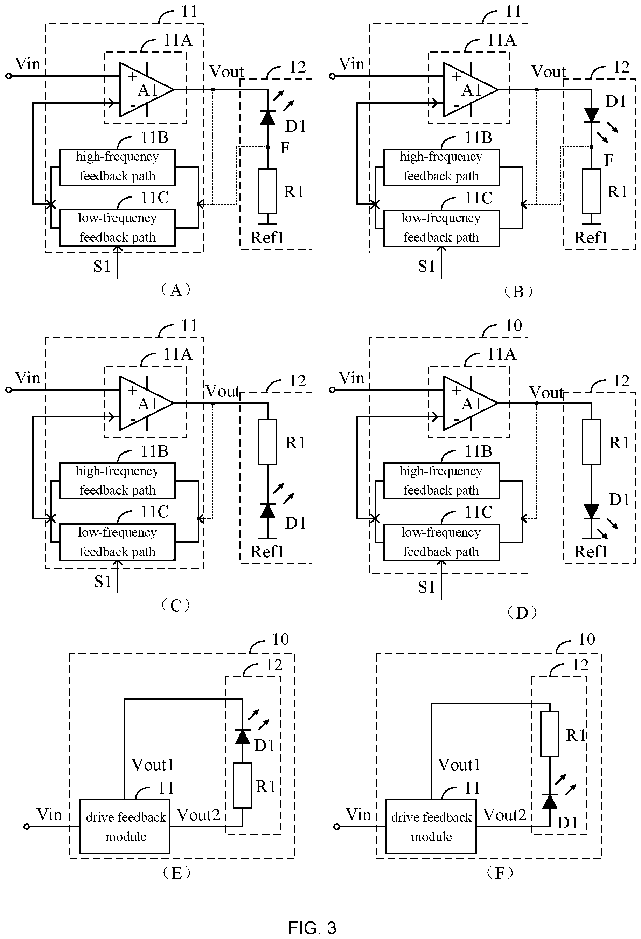

In an embodiment, the laser emission module 12 includes a laser emission tube D1 and a first resistor R1. The first resistor R1 is a current limiting resistor. The first preset reference voltage can be a first preset power supply voltage VCC1 or a first preset reference voltage Ref1. Two construction manners of the laser emission module 12 are provided. The first construction manner of the laser emission module 12 can refer to (C) and (D) in FIG. 3. One of the anode and cathode of the laser emission tube D1 can be connected to the single-ended signal (Vout) output by the drive feedback module 11 through the first resistor R1. Another one of the anode and cathode is connected to the first preset reference voltage. Specifically, the anode of the laser emission tube D1 is connected to the single-ended signal (Vout) through the first resistor R1. The cathode is accessed to the first preset reference voltage Ref1. Or, the cathode of the laser emission tube D1 is accessed to the single-ended signal (Vout) through the first resistor R1. The anode is accessed to the first preset reference voltage. The second construction manner of the laser emission module 12 can refer to (A) and (B) in FIG. 3. One of the anode and cathode of the laser emission tube D1 is directly accessed to the single-ended signal (Vout) output by the drive feedback module 11. The other of the anode and the cathode can be accessed to the first preset reference voltage Ref1 through the first resistor R1. Specifically, the anode of the laser emission tube D1 can be directly accessed to the single-ended signal (Vout). The cathode can be accessed to the first preset reference voltage Ref1 through the first resistor R1. Or, the cathode of the laser emission tube D1 can be directly accessed to the single-ended signal. The anode can be accessed to the first preset reference voltage Ref1 through the first resistor R1.

When the output signal of the drive feedback module 11 includes a first output signal (Vout1) and a second output signal (Vout2) that are differential signals. Two construction manners of the laser emission module 12 are further provided here. The first construction manner of the laser emission module 12 can be referred to (E) in FIG. 3. The cathode of the laser emission tube D1 is accessed to the first output signal (Vout1). The anode is accessed to the second output signal (Vout2) through the first resistor R1. Of course. It can further be that the anode of the laser emission tube D1 is accessed to the first output signal (Vout1). The cathode is accessed to the second output signal (Vout2) through the first resistor R1. The second construction manner of the laser emission module 12 can be referred to (F) in FIG. 3. The cathode of the laser emission tube D1 is accessed to the first output signal (Vout1) through the first resistor R1. The anode is accessed to the second output signal (Vout2). Of course. It can further be that the anode of the laser emission tube D1 is accessed to the first output signal (Vout1) through the first resistor R1. The cathode is accessed to the second output signal (Vout2).

In an embodiment, the connection point between the laser emission tube D1 and the first resistor R1 is the end F.

As shown in (A) and (B) in FIG. 3. The drive feedback module 11 further has a second feedback input point. The second feedback input end of the drive feedback module 11 is connected to the end F or the output end of the drive feedback module 11 to realize its own negative feedback regulation by accessing its own output signal or the signal of the end F. It is beneficial to improve the consistency between the output signal of the drive feedback module 11 and the input analog signal. It should be noted that when the laser emission tube D1 is connected to the output end of the drive feedback module 11 through the first resistor R1, there is no end F in the circuit, which can be specifically shown in (C) and (D) in FIG. 3.

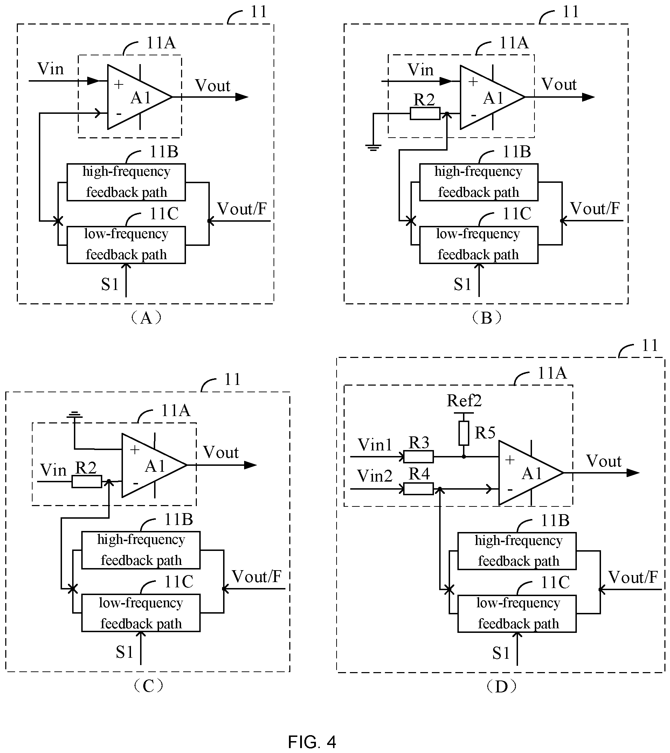

In an embodiment, as shown in FIG. 3 and FIG. 4, the drive feedback module 11 includes a first amplifier circuit 11A, a high-frequency feedback path 11B and a low-frequency feedback path 11C.

The first input end of the first amplifier circuit 11A is connected to the input end of the drive feedback module 11. The output end of the first amplifier circuit 11A is connected to the output end of the drive feedback module 11. The first input end of the low-frequency feedback path 11C is connected to the first feedback input end of the drive feedback module 11. The input end of the high-frequency feedback path 11B is connected to the second feedback input end of the drive feedback module 11. The output end of the high-frequency feedback path 11B and the output end of the low-frequency feedback path 11C are respectively connected to the second input end of the first amplifier circuit 11A.

The high-frequency feedback path 11B can be connected to the output signal of the drive feedback module 11 or the signal at the end F. After separating the intermediate-frequency component and high-frequency components, the separated intermediate-frequency component and high-frequency components can be fed back to the second input end of the first amplifier circuit 11A. The low-frequency feedback path 11C can feed back the low-frequency analog signal S1 to the second input end of the first amplifier circuit 11A. In this way, the input signal at the second input end of the first amplifier circuit 11A can be regarded as having a full-band component. Therefore, the first amplifier circuit 11A can use the input signal at the second input end to perform operational amplification on the input analog signal connected and then output it, thereby realizing the negative feedback regulation of the input analog signal by the first amplifier circuit 11A.

In an embodiment, as shown in FIG. 3 and FIG. 4, the first amplifier circuit 11A comprises a first operational amplifier A1.

The quantity of the first input end of the first amplifier circuit 11A is one. The non-inverting input end or the inverting input end of the first operational amplifier A1 is the first input end of the first amplifier circuit 11A. The inverting input end of the first operational amplifier A1 is the second input end of the first amplifier circuit 11A. The non-inverting input end or the inverting input end of the first operational amplifier A1 is accessed to the input analog signal of the single-ended signal through the second resistor R2.

In an embodiment, the quantity of first input ends of the first amplifier circuit 11A is two. The non-inverting input end and the inverting input end of the first operational amplifier are respectively the two first input ends of the first amplifier circuit 11A. The inverting input end of the first operational amplifier A1 is the second input end of the first amplifier circuit 11A. The non-inverting input end of the first operational amplifier A1 is accessed to the input analog signal of the differential signal through the third resistor R3; and the inverting input end of the first operational amplifier A1 is accessed to the input analog signal of the differential signal through the fourth resistor R4. The non-inverting input end of the first operational amplifier A1 is further accessed to the second preset reference voltage Ref2 through the fifth resistor R5.

When the input analog signal is a single-ended signal (Vout), either the non-inverting input end or the inverting input end of the first operational amplifier A1 can be connected to the input analog signal of the single-ended signal through the second resistor R2. The resistance of the second resistor R2 is not less than 0Ω. When the non-inverting input end is configured to access the input analog signal, the resistance of the second resistor R2 can be selected as 0Ω or greater than 0Ω according to actual needs. When the inverting input end is configured to access the input analog signal, the resistance of the second resistor R2 can be selected from a range greater than 0Ω according to actual needs. At this time, the non-inverting input end can be connected to a preset reference voltage or connected to the ground. Specifically refer to (B) and (C) in FIG. 4, it should be noted that when the resistance value of the second resistor R2 is 0Ω, it can be regarded as a wire. Therefore, the second resistor R2 is not shown in (A) in FIG. 3.

The first operational amplifier A1 can perform operational amplification on the input analog signal and output it in the form of a single-ended signal or a differential signal. The non-inverting/inverting input end of the first operational amplifier A1 that is not connected to the input analog signal can be accessed to a preset reference voltage or ground. The inverting input end of the first operational amplifier A1 can be accessed to the output signals of the high-frequency feedback path 11B and the low-frequency feedback path 11C respectively to be used as a feedback signal to realize negative feedback regulation of the input analog signal. It is beneficial to improve the consistency between the output signal of the first operational amplifier A1 and the input analog signal. It should be noted that when the first amplifier circuit 11A outputs a differential signal and the input analog signal is a single-ended signal, the first amplifier circuit 11A can be implemented by a two-stage amplifier circuit. The first-stage amplifier circuit can be a single-ended signal input and a single-ended signal output. The second-stage amplifier circuit can be a single-ended signal input and a differential signal output. And the inverting input end of the operational amplifier in the first-stage amplifier circuit is configured to be accessed to the feedback signal. The inverting input end of the operational amplifier in the second-stage amplifier circuit is configured not to be accessed to the feedback signal. In other words, at this time, the first operational amplifier A1 is provided in the first stage amplifier circuit.

It can be understood that the low-frequency operating point of the first operational amplifier A1 is the low-frequency operating point of the drive feedback module 11 and the low-frequency operating point of the analog emission unit 10. Therefore, the low-frequency component in the input analog signal can be corrected by the low-frequency analog signal S1 accessed to its inverting input end.

When the input analog signal is a differential signal, for details, as shown in (D) in FIG. 4. The non-inverting input end is connected to the input analog signal through the third resistor R3 and the inverting input end of the first operational amplifier A1 is connected to the input analog signal through the fourth resistor R4. The non-inverting input end is connected to the second preset reference voltage Ref2 through the fifth resistor R5. At this time, the input analog signal may include a first input analog signal (Vin1) and a second input analog signal (Vin2) that are differential signals. The first operational amplifier A1 can perform operational amplification on the accessed first input analog signal (Vin1) and the second input analog signal (Vin2) and output in the form of a single-ended signal (Vout) or a differential signal (Vout1 and Vout2). It should be noted that when the first operational amplifier A1 outputs a differential signal (Vout1 and Vout2), the first operational amplifier A1 does not have a negative feedback path.

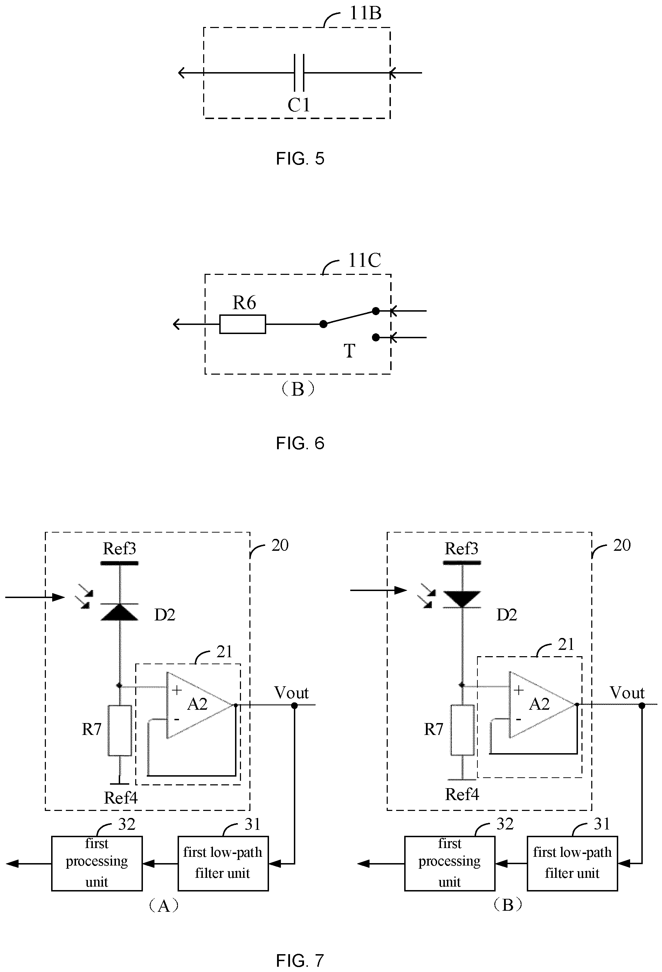

In an embodiment, as shown in FIG. 5, the high-frequency feedback path 11B can be implemented by a capacitor device, namely, a first capacitor C1. The quantity of the first capacitor C1 can be determined according to actual needs, and no limitation is made here. The two ends of the first capacitor C1 can be connected to the input end and the output end of the high-frequency feedback path 11B respectively. The characteristics of the capacitor device that passes high frequencies and blocks low frequencies are used to separate the intermediate-frequency component and high-frequency components of the output signal of the first amplifier circuit 11A.

In an embodiment, as shown in FIG. 6, the low-frequency feedback path 11C further has a second input end, and the second input end of the low-frequency feedback path 11C is connected to the second feedback input end of the drive feedback module 11.

When the laser transmission circuit of the present application works in the normal mode, the low-frequency feedback path receives the low-frequency analog signal S1 from the first input end. When the laser transmission circuit of the present application works in the gain calibration mode, the low-frequency feedback path accesses the input signal from the second input end.

The low-frequency feedback path 11C includes a one-or-two switch T and a sixth resistor R6.

The first input end of the two-to-one-one switch T is connected to the first input end of the low-frequency feedback path 11C to access the low-frequency analog signal S1. The second input end of the two-to-one switch T is connected to the second input end of the low-frequency feedback path 11C. One end of the sixth resistor R6 is connected to the output end of the two-to-one- one switch T, and another end of the sixth resistor R6 is connected to the output end of the low-frequency feedback path 11C.

The two-to-one- one switch T is under the control of the main control unit in the device where the laser transmission device is located to access the first input end and the output end or access the second input end and the output end. When the laser transmission circuit of the present application works in the normal mode, the first input end and the output end are connected. The two-to-one switch T can output the low-frequency analog signal S1 to the first amplifier circuit 11A through the sixth resistor R6, so that the first amplifier circuit 11A can perform negative feedback adjustment on the input analog signal according to the accessed low-frequency analog signal S1.

When the laser transmission circuit of the present application works in the gain calibration mode, the second input end and the output end are connected. The two-to-one-one switch T can output the output signal of the first amplifier circuit 11A through the sixth resistor R6, so that the first amplifier circuit 11A can perform negative feedback adjustment on the input analog signal according to the output of the first amplifier circuit 11A or the end F signal. The sixth resistor R6 can be a feedback resistor.

As shown in FIG. 7, according to an embodiment of the present application, the analog receiving unit 20 includes: a second amplifier circuit 21, a laser receiving tube D2 and a seventh resistor R7. The output end of the second amplifier circuit 21 is connected to the output end of the analog receiving unit 20.

The first end of the laser receiving tube D2 is configured to access the third preset reference voltage Ref3. The second end of the laser receiving tube D2 is respectively connected to one end of the seventh resistor R7 and an input end of the second amplifier circuit 21, and another end of the seventh resistor R7 is configured to access the fourth preset reference voltage Ref4.

In an embodiment, the second amplifier circuit 21 can be implemented by an operational amplifier. In an embodiment, it can be implemented by an amplifier circuit constructed by discrete electronic devices such as triodes and resistors, which is not limited here. The operation process of the analog receiving unit 20 is explained in detail by taking the implementation of the second amplifier circuit 21 by an operational amplifier (hereinafter referred to as the second operational amplifier A2) as an example.

As shown in (A) and (B) in FIG. 7, the laser receiving tube D2 may have an anode and a cathode. The second operational amplifier A2 may have a non-inverting input end and an inverting input end. When the first end is an anode and the second end is a cathode, the third preset reference voltage Ref3 is less than the fourth preset reference voltage Ref4. The laser receiving tube D2 generates a corresponding induced current according to the received analog laser signal. The induced current flows to the laser receiving tube D2 through the seventh resistor R7. When the first end is a cathode and the second end is an anode, the third preset reference voltage Ref3 is greater than the fourth preset reference voltage Ref4. The laser receiving tube D2 generates a corresponding induced current according to the received analog laser signal. It flows to the fourth preset reference voltage Ref4 through the seventh resistor R7. The voltage signal formed at the connection between the laser receiving tube D2 and the seventh resistor R7 is amplified by the second operational amplifier A2 and output as an output analog signal. At this time, the first input end of the second amplifier circuit 21 may be the non-inverting input end of the second operational amplifier A2. The inverting input end of the second operational amplifier A2 may be accessed to the preset reference voltage. In an embodiment, it may also be connected to the output end of the second operational amplifier A2 to form negative feedback regulation. Of course, it is understandable that those skilled in the art can use the second operational amplifier A2 and the resistor device to construct an operational circuit such as a non-inverting amplifier circuit, an inverting amplifier circuit or a voltage follower circuit to implement the second amplifier circuit 21 according to the technical solution of the present application, which will not be repeated here.

In an embodiment, the first end of the laser receiving tube D2 is configured to access the third preset reference voltage Ref3. The second end of the laser receiving tube D2 is respectively connected to one end of the seventh resistor R7 and the first input end of the second amplifier circuit 21. Another end of the seventh resistor R7 is connected to the output end of the second amplifier circuit 21. The second input end of the second amplifier circuit 21 is configured to access the fourth preset reference voltage Ref4.

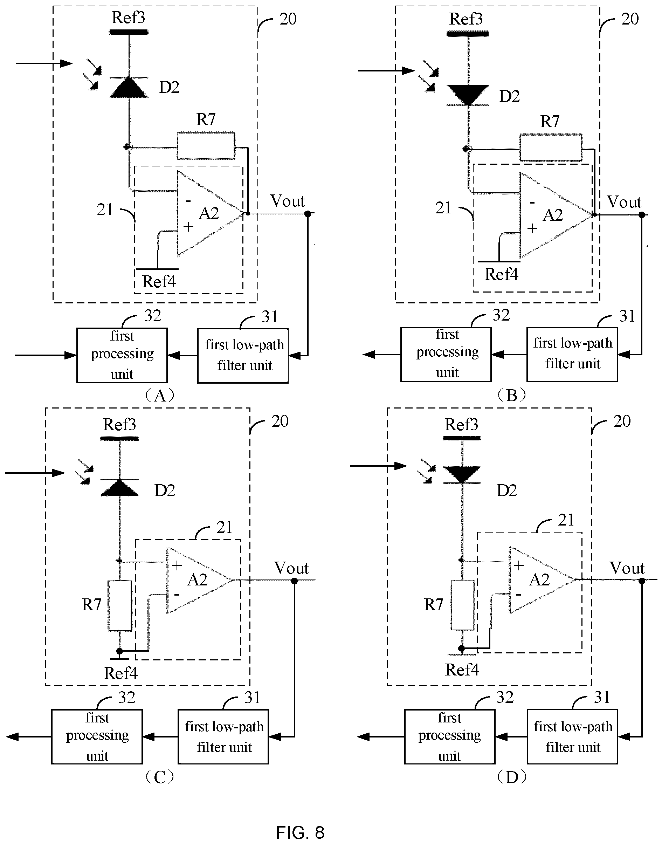

As shown in (A) and (B) in FIG. 8. In an embodiment, the first input end and the second input end of the second amplifier circuit 21 can be the inverting input end and the non-inverting input end of the second operational amplifier A2, respectively. When the first electrode of the laser receiving tube D2 is an anode and the second electrode is a cathode, the laser receiving tube D2 generates a corresponding induced current according to the received analog laser signal. The induced current flows from the output end of the second operational amplifier A2 via the seventh resistor R7 through the laser receiving tube D2. When the first electrode of the laser receiving tube D2 is a cathode and the second electrode is an anode, the laser receiving tube D2 generates a corresponding induced current according to the received analog laser signal and flows into the output end of the second operational amplifier A2 through the seventh resistor R7.

In an embodiment, the first end of the laser receiving tube D2 is configured to access the third preset reference voltage Ref3. The second end of the laser receiving tube D2 is connected to one end of the seventh resistor R7, another end of the seventh resistor R7 is configured to access the fourth preset reference voltage Ref4. The first input end and the second input end of the second amplifier circuit 21 are respectively connected to the two ends of the seventh resistor R7.

As shown in (C) and (D) in FIG. 8, in an embodiment, the laser receiving tube D2 can generate a corresponding induced current according to the received analog laser signal and output it to the seventh resistor R7, so that a corresponding voltage signal can be formed at both ends of the seventh resistor R7. The second operational amplifier A2 can be a differential amplifier. The non-inverting input end and the inverting input end of the second operational amplifier A2 can be respectively connected to the voltage signal formed at both ends of the seventh resistor R7 to form a differential input. And the two connected voltage signals can be operationally amplified and output in the form of a single-ended signal or a differential signal.

It should be noted that the seventh resistor R7 can be a sampling resistor. The first preset voltage Ref1, the second preset voltage RER2, the third preset voltage RER3, and the fourth preset voltage RER4 recorded in the present application can be obtained by outputting the power management circuit in the device. And the voltage values of the three can be the same or different. This is not limited here. In an embodiment, the first preset voltage Ref1, the second preset voltage RER2, the third preset voltage RER3, or the fourth preset voltage RER4 can be implemented using a ground voltage.

As shown in FIG. 8, according to an embodiment of the present application, the digital feedback path 30 includes a first low-pass filter unit 31, a first processing unit 32, and a second processing unit 33.

An input end of the first low-pass filter unit 31 is connected to the input end of the digital feedback path 30. The first low-pass filter unit 31 is configured to emit the analog electrical signal after low-pass filtering.

An input end of the first processing unit 32 is connected to the output end of the first low-pass filter unit 31. The first processing unit 32 is configured to convert the analog electrical signal after low-pass filtering into a digital signal and then output the digital signal.

An output end of the second processing unit 33 is connected to the output end of the digital feedback path 30. The second processing unit 33 is configured to receive the digital signal emitted by the first processing unit 32, convert the digital signal into a low-frequency analog signal S1, and output the low-frequency analog signal to the output end of the digital feedback path 30.

In an embodiment, the first low-pass filter unit 31 and the first processing unit 32 can form a digital filter transmission path in the digital feedback path 30. The first low-pass filter unit 31 is configured to perform low-pass filtering on the output analog signal. After separating the low-frequency component therein, the analog electrical signal representing the low-frequency component is output to the first processing unit 32. After being converted into a digital signal of a corresponding form by the first processing unit 32, the digital signal is transmitted. The second processing unit 33 can form a digital receiving feedback path in the digital feedback path 30. The second processing unit 33 is configured to receive and identify the digital signal of the corresponding form transmitted by the first processing unit 32, and it is configured to output the low-frequency analog signal S1 to the analog emission unit 10 according to the received digital signal. Thereby, the feedback of abnormal low-frequency components is realized.

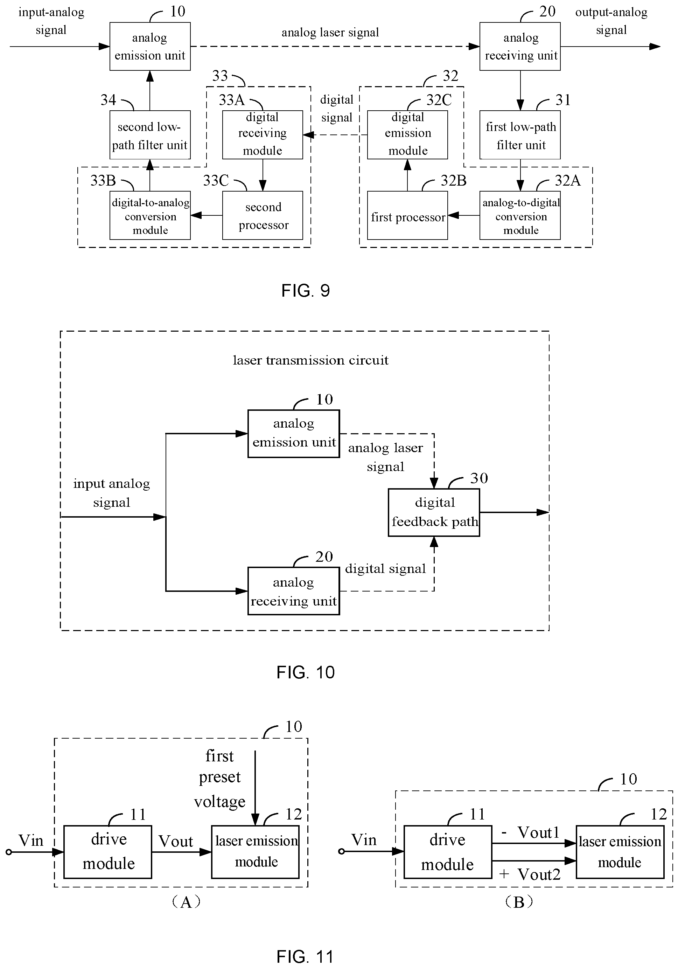

In an embodiment, as shown in FIG. 9, the first processing unit 32 includes an analog-to-digital conversion module 32A, a first processor 32B, and a digital emission module 32C. The input end of the analog-to-digital conversion module 32A is connected to the input end of the first processing unit 32. The output end of the analog-to-digital conversion module 32A is connected to the input end of the first processor 32B. The output end of the first processor 32B is connected to the input end of the digital emission module 32C. The digital emission module 32C is configured to emit the digital signals.

In an embodiment, the analog-to-digital conversion module 32A converts the analog electrical signal output by the first low-pass filter unit 31 into a digital electrical signal, and then outputs it to the first processor 32B. The first processor 32B may be a microprocessor or a main control chip such as a micro controller unit (MCU), a digital signal processor (DSP), or a field programmable gate array (FPGA), which is not limited here. The first processor 32B may perform signal processing on the digital electrical signal output by the analog-to-digital conversion module 32A, and may output the digital electrical signal after signal processing to the digital emission module 32C, so that the digital electrical signal after signal processing may drive the digital emission module 32C to emit a digital signal in a corresponding form, thereby realizing the transmission of digital signals. Of course, the analog-to-digital conversion module 32A may also be integrated into the first processor 32B. Since a digital electrical signal is configured to drive the digital emission module 32C to work, the digital feedback path may be effectively prevented from being affected by the above-mentioned influencing factors, thereby affecting the transmission of digital signals, which is conducive to improving the stability of the digital signal transmission process. In addition, it is relatively easy for the first processor 32B or the analog-to-digital conversion module 32A to achieve high precision in practical applications, thereby also helping to reduce the difficulty of achieving high precision of digital signals.

In an embodiment, the second processing unit 33 includes a digital receiving module 33A, a second processor 33B, and a digital-to-analog conversion module 33C. The digital receiving module 33A is configured to receive the digital signal transmitted by the digital emission module 32C. The output end of the digital receiving module 33A is connected to the input end of the second processor 33B. The output end of the second processor 33B is connected to the input end of the digital-to-analog conversion module 33C. The output end of the digital-to-analog conversion module 33C is connected to the output end of the second processing unit 33.

The digital receiving module 33A can receive digital signals in corresponding forms, and can convert digital signals in corresponding forms into digital electrical signals and then output them to the second processor 33B. The second processor 33B can be a microprocessor or a main control chip such as MCU, DSP, FPGA, etc., which is not limited here. The second processor 33B can perform signal processing on the digital electrical signal output by the digital receiving module 33A, and can output the digital electrical signal after signal processing to the digital-to-analog conversion module 33C. After being converted into a low-frequency analog signal S1 by the digital-to-analog conversion module 33C, it is output to the feedback input end of the analog emission unit 10, thereby realizing the reception feedback of the digital signal. The digital-to-analog conversion module 33C can further be integrated in the second processor 33B. In addition, the difficulty of the second processor 33B or the digital-to-analog conversion module 33C to achieve high precision in practical applications is relatively low. Therefore, it is also conducive to reducing the difficulty of achieving high precision of the low-frequency analog signal S1.

In an embodiment, the digital emission module 32C is a laser emitter, and the digital receiving module 33A is a laser receiver.

The laser transmitter can output a digital signal in the form of laser to the laser receiver under the drive of a digital electrical signal, so that the laser receiver can generate and output a corresponding digital electrical signal according to the received digital signal in the form of laser, thereby realizing laser transmission of low-frequency components. It should be noted that, since is it is driven by the digital electrical signal, the electro-optical conversion effect of the laser transmitter at this time will not be affected by environmental factors or changes in its own working conditions, so that the laser receiver can restore the output without offset and represent the digital electrical signal of the standard low-frequency component.

In an embodiment, the digital emission module 32C is a wireless transmitting circuit, and the digital receiving module 33A is a wireless receiving circuit.

The wireless transmitting circuit and the wireless receiving circuit may be nearfield communication circuits such as infrared communication circuits, Bluetooth communication circuits, ultra-wideband communication circuits, ZigBee communication circuits, and radio frequency identification (RFID) communication circuits. Or they may also be far-field communication circuits such as 3G communication circuits, 4G communication circuits, 5G communication circuits, wireless fidelity (Wi-Fi) communication circuits, WiGig communication circuits, and wireless broadband Internet communication circuits, which is not limited here. The wireless transmitting circuit may be driven by a digital electrical signal to output a digital signal in the form of infrared, electromagnetic waves, etc., to the wireless receiving circuit, so that the wireless receiving circuit can generate and output a corresponding digital electrical signal according to the received digital signal in the form of infrared, electromagnetic waves, etc., thereby realizing wireless communication transmission of low-frequency components.

In an embodiment, the digital emission module 32C is an opto-coupler unit. The digital receiving module 33A is a main controller.

The opto-coupler unit can access the digital electrical signal output by the first processor 32B through the primary side, and can generate and output the corresponding digital electrical signal through the secondary side under the drive of the digital electrical signal, so as to be received and identified by the main controller in the digital receiving feedback path, thereby realizing the communication transmission of the low-frequency component.

In an embodiment, the digital emission module 32C is a main controller, and the digital receiving module 33A is an opto-coupler unit.

The main controller can access the digital electrical signal output by the first processor 32B, and can output the digital electrical signal after signal processing, so as to provide the primary side receiving identification of the opto-coupler unit in the digital receiving feedback path, thereby realizing the communication transmission of the low-frequency component.

In an embodiment, the digital feedback path 30 further includes a second low-pass filter unit 34. An input end of the second low-pass filter unit 34 is connected to an output end of the second processing unit 33. An output end of the second low-pass filter unit 34 is connected to an output end of the digital feedback path 30.

The second low-pass filter unit 34 is configured to output the low-frequency analog signal S1 output by the second processing unit 33 to the analog emission unit 10 after low-pass filtering, so as to ensure that there are no intermediate-frequency and high-frequency components in the low-frequency correction signal accessed to the analog emission unit 10, which is conducive to improving the correction accuracy of the analog emission unit 10 for the low-frequency components.

### Second embodiment

The present application provides a laser transmission circuit.

In the linear transmission of laser signals, two laser diodes, laser emission tube D1 and laser receiving tube D2, are usually required. The laser emission tube D1 can output the corresponding analog signal in the form of laser according to the accessed analog electrical signal, that is, the analog laser signal. In actual use, it is found that the laser signal is easily affected by the laser diode, especially the laser emission tube and the transmission environment during the transmission process. As a result, the analog laser signal output according to the low-frequency component in the analog electrical signal has errors, which leads to an offset in the low-frequency component of the analog electrical signal restored by the laser receiving tube D2 in the receiving unit 30. In this way, for electronic device, especially electronic measuring device such as oscilloscopes that have multiple signal transmission links, the offset of the low-frequency components generated in each signal transmission link will be superimposed in turn. Ultimately, the obtained analog electrical signal has extremely low accuracy, which is precisely the difficulty that the current electronic measurement industry cannot use laser signals to transmit analog signals. It should be noted that the sources of influence of the laser emission tube and the laser receiving tube may include but are not limited to: operating temperature and jitter of the applied instrument. The sources of influence of the transmission environment may include but are not limited to: ambient temperature, ambient light, ambient humidity, and transmission fiber jitter.

In view of the above problem, as shown in FIG. 10, according to an embodiment of the present application, the laser transmission circuit includes an analog emission unit, a digital emission unit, and a receiving unit.

An input end of the analog emission unit 10 is configured to access an input analog signal of the laser transmission circuit, and emit an analog laser signal corresponding to the input analog signal.

An input end of the digital emission unit 20 is configured to receive an input analog signal of the laser transmission circuit, and emit a digital signal corresponding to a low-frequency component of the input analog signal.

The receiving unit 30 is configured to receive the analog laser signal output by the analog emission unit 10 and the digital signal output by the digital emission unit 20 and to generate digital electrical signals and analog electrical signals respectively.

The receiving unit 30 is further used to correct the generated analog electrical signal according to the generated digital electrical signal, and output the corrected analog electrical signal.

In an embodiment, the input end of the analog emission unit 10 can be connected to the input end of the laser transmission circuit to access the analog electrical signal to be transmitted, that is, the input analog signal. And according to the input analog signal, an analog signal in the form of a laser can be output, that is, an analog laser signal, to be received by the receiving unit 30. It should be noted that the analog laser signal output by the analog emission unit 10 has all the signal components of the input analog signal.

The input end of the digital emission unit 20 can be connected to the input end of the laser transmission circuit to access the input analog signal to be transmitted and separate the low-frequency component therein. According to the separated low-frequency component, a digital signal of a corresponding form can be emitted to be received by the receiving unit 30. It should be noted that the input analog signal has three signal components: a low-frequency component, an intermediate-frequency component and a high-frequency component. In other words, the digital signal transmitted by the digital emission unit 20 has the low-frequency component of the input analog signal.

The receiving unit 30 can receive the analog laser signal through the laser receiving tube D2. And the digital receiving unit 32 such as the wireless receiving unit, the laser receiver, the wired receiving unit or the main controller can receive the digital signal in the corresponding form. And the received analog laser signal and digital signal can be converted into analog electrical signals and digital electrical signals in the form of electrical signals respectively. The analog electrical signal is corrected by the digital electrical signal. It should be noted that. Since the analog electrical signal corresponds to all signal components of the input analog signal. The digital electrical signal corresponds to the low-frequency component of the input analog signal. And since the digital emission unit 20 transmits the digital signal in the corresponding form and the receiving unit 30 converts the received digital signal into a digital electrical signal, the working process will not be affected by the laser diode and the transmission environment. Therefore, the digital electrical signal can be characterized as a standard low-frequency component that is not affected by the above. Therefore, the receiving unit 30 can determine the low-frequency offset of the low-frequency component in the input analog signal after being affected by the signal processing of the analog electrical signal and the digital electrical signal. And the low-frequency component in the analog electrical signal can be corrected by using the determined low-frequency offset. Specifically, the abnormal low-frequency component after being affected is obtained according to the analog electrical signal. And the corresponding standard low-frequency component is obtained according to the digital electrical signal. The abnormal low-frequency component can be compared with the standard low-frequency component to determine the low-frequency offset. The receiving unit can further perform corresponding operations on the low-frequency offset and the abnormal low-frequency component in the analog electrical signal until the abnormal low-frequency component in the analog electrical signal can be corrected to the standard low-frequency component.

As such, by repeating the above process, the abnormal low-frequency component in the analog electrical signal can be corrected in real time to a standard low-frequency component that is not affected by the laser diode and the transmission environment, and the intermediate-frequency component and the high-frequency component themselves are not affected. Therefore, the corrected analog electrical signal can be regarded as not being affected by the laser diode and the transmission environment during the laser transmission process. And it can be output as the output signal of the laser transmission circuit (hereinafter "output analog signal" means "output signal of the laser transmission circuit"). Thereby, linear laser transmission of the analog signal is realized, and the problem of the error caused by the laser signal to the analog signal during transmission is solved. In addition, the technical solution of the present application also enables electronic measuring instruments such as oscilloscopes to adopt the solution of laser transmission of analog signals, which overcomes the difficulties of the electronic measurement industry in adopting laser transmission of analog signals, improves the diversity of analog signal transmission, and is conducive to improving the display accuracy of electronic measuring instruments for analog signals.

As shown in FIG. 11, according to an embodiment of the present application, the analog emission unit 10 includes: a drive module 11, and a laser emission module 12.

An input end of the drive module 11 is connected to the input end of the analog emission unit 10.

The first end of the laser emission module 12 is connected to the output end of the drive module 11. The second end of the laser emission module 12 is configured to access a first preset voltage. Or, the first end of the laser emission module 12 is connected to the positive output end of the drive module 11. The second end of the laser emission module 12 is connected to the negative output end of the drive module 11 to access the differential signal output by the drive module 11.

In an embodiment, the drive module 11 is configured to perform operational amplification on the input analog signal and then output it to the laser emission module 12, so as to drive the laser emission module 12 to emit an analog laser signal. Two driving manners of the drive module 11 to drive the laser emission module 12 are provided here: the first driving manner can be specifically referred to FIG. 11 (A). The drive module 11 outputs a single-ended signal (Vout) to the first end of the laser emission module 12, so that the laser emission module 12 can emit a corresponding analog laser signal according to the single-ended signal (Vout) and the first preset voltage respectively accessed to the two ends. The second driving manner can be specifically referred to FIG. 11 (B). The drive module 11 outputs a differential signal (Vout1 and Vout2) to the two ends of the laser emission module 12, so that the laser emission module 12 can emit a corresponding analog laser signal according to the differential signal (Vout1 and Vout2) accessed to the two ends.

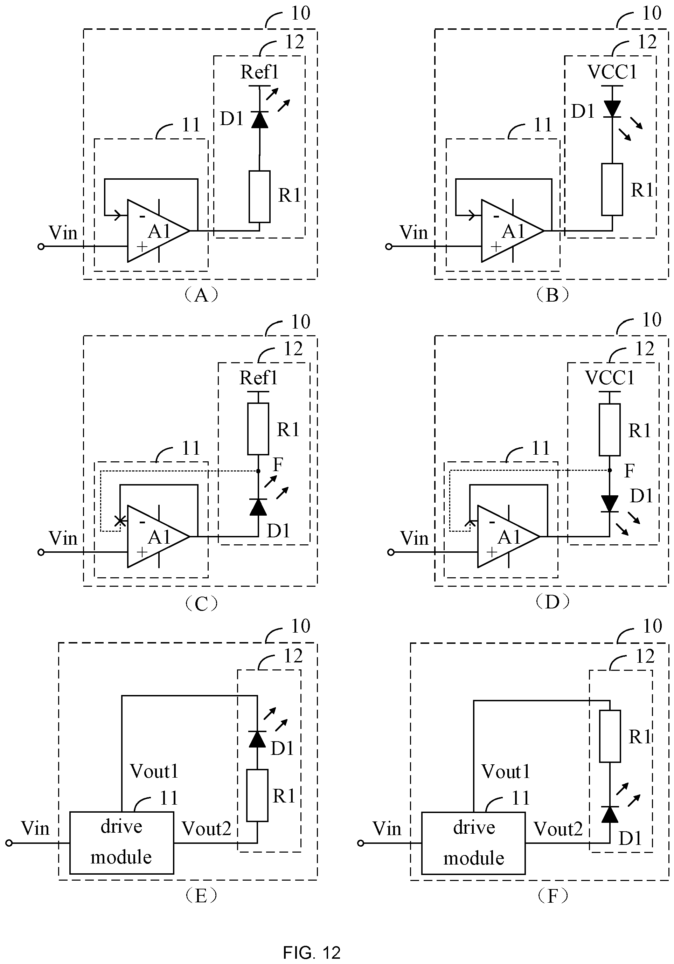

In an embodiment, the laser emission module 12 includes a laser emission tube D1 and a first resistor R1. When the output signal of the drive module 11 is a single-ended signal (Vout), the first preset voltage may be a first preset power supply voltage VCC1 or a first preset reference voltage Ref1. Two construction manners of the laser emission module 12 are provided here. The construction manner of the first laser emission module 12 can refer to (A) and (B) in FIG. 12. One of the anode and the cathode of the laser emission tube D1 can be accessed to the single-ended signal (Vout) output by the drive module 11 through the first resistor R1. The other of the anode and the cathode is accessed to the first preset voltage. Specifically, the anode of the laser emission tube D1 is accessed to the single-ended signal (Vout) through the first resistor R1. The cathode is accessed to the first preset reference voltage Ref1. Or, the cathode of the laser emission tube D1 is accessed to the single-ended signal (Vout) through the first resistor R1. The anode is accessed to the first preset power supply voltage VCC1. The construction manner of the second laser emission module 12 can refer to (C) and (D) in FIG. 12. One of the anode and cathode of the laser emission tube D1 is accessed to the single-ended signal (Vout) output by the drive module 11. The other of the anode and cathode can be accessed to the first preset voltage through the first resistor R1. Specifically: the anode of the laser emission tube D1 is accessed to the single-ended signal (Vout). The cathode can be accessed to the first preset reference voltage Ref1 through the first resistor R1. Or, the cathode of the laser emission tube D1 is accessed to the single-ended signal through the first resistor R1. The anode can be accessed to the first preset power supply voltage VCC1 through the first resistor R1.

When the output signal of the drive module 11 includes a first output signal (Vout1) and a second output signal (Vout2) that are differential signals. Two construction manners of the laser emission module 12 are further provided here. The first construction manner of the laser emission module 12 can be referred to (E) in FIG. 12. The cathode of the laser emission tube D1 is accessed to the first output signal (Vout1). The anode is accessed to the second output signal (Vout2) through the first resistor R1. Of course. It is also possible that the anode of the laser emission tube D1 is accessed to the first output signal (Vout1). The cathode is accessed to the second output signal (Vout2) through the first resistor R1. The second construction manner of the laser emission module 12 can be referred to (F) in FIG. 12. The cathode of the laser emission tube D1 is accessed to the first output signal (Vout1) through the first resistor R1. The anode is accessed to the second output signal (Vout2). Of course. It is also possible that the anode of the laser emission tube D1 is accessed to the first output signal (Vout1) through the first resistor R1, and the cathode is accessed to the second output signal (Vout2).

In an embodiment, when the first end of the laser emission tube D1 is connected to the first end of the laser emission module 12, and the other end of the laser emission tube D1 is connected to the second end of the laser emission module 12 through the first resistor R1, the connection point between the laser emission tube D1 and the first resistor R1 is the end F, the drive module 11 includes a first amplifier circuit, and the first amplifier circuit has a non-inverting input end and an inverting input end.

In an embodiment, the first amplifier circuit can be implemented by an operational amplifier or an operational amplifier chip. In an embodiment, it can be implemented by an amplifier circuit constructed by discrete electronic devices such as triodes and resistors, which is not limited here. Here, the working principle of the drive module 11 is explained in detail by taking the implementation of the first amplifier circuit by an operational amplifier (hereinafter referred to as the first operational amplifier A1) as an example. The non-inverting input end of the first operational amplifier A1 can be the non-inverting input end of the first amplifier circuit, the inverting input end of the first operational amplifier A1 can be the inverting input end of the first amplifier circuit, and the output end of the first operational amplifier A1 can be the output end of the first amplifier circuit.

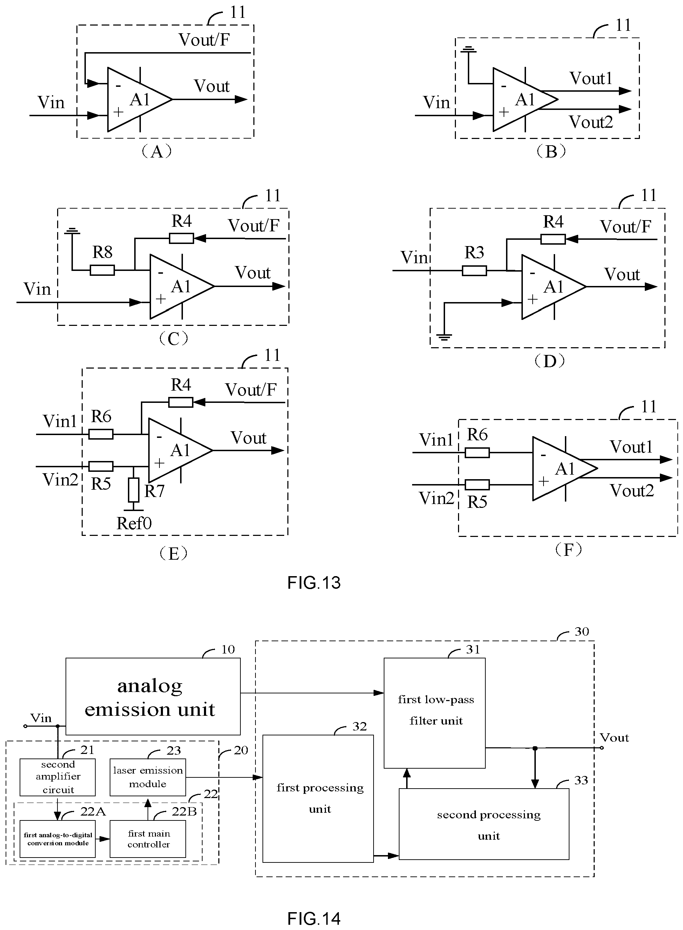

When the input analog signal is a single-ended signal (Vout), either the non-inverting input end or the inverting input end of the first operational amplifier A1 can be connected to the input analog signal of the single-ended signal through the third resistor R3. The resistance of the third resistor R3 is not less than 0Ω. When the non-inverting input end is configured to access the input analog signal, the resistance of the third resistor R3 can be selected as 0Ω or greater than 0Ω according to actual needs. At this time, the inverting input end can be connected to a preset reference voltage or connected to the ground through the eighth resistor R8. Specifically refer to (C) in FIG. 13. When the inverting input end is configured to access the input analog signal, the resistance of the third resistor R3 can be selected from a range greater than 0Ω according to actual needs. And at this time, the non-inverting input end can be connected to a preset reference voltage or connected to the ground, which can be specifically referred to (D) in FIG. 13.

The first operational amplifier A1 can perform operational amplification on the input analog signal connected. Output in the form of a single-ended signal or a differential signal, which can be specifically referred to (A) and (B) in FIG. 13 respectively. It should be noted that when the first operational amplifier A1 outputs a differential signal. When the input analog signal connected is a single-ended signal. The first operational amplifier's non-inverting/inverting input end that is not connected to the input analog signal can be connected to a preset reference voltage or ground. The inverting input end of the first operational amplifier A1 can be connected to the output end of the first operational amplifier A1 or the end F in the laser emission module 12 through the fourth resistor R4. The output signal connected to the first operational amplifier A1 or the signal at the end F is used as a feedback signal to realize the negative feedback regulation of the first operational amplifier A1, which is beneficial to improve the consistency between the output signal of the first operational amplifier A1 and the input analog signal, which can be specifically referred to (C) and (D) in FIG. 13. The resistance value of the fourth resistor is not less than 0Ω. The negative feedback path of the end F can refer to the dotted line path in (C) and (D) in FIG. 12. The negative feedback path of the output end of the first operational amplifier A1 can refer to the solid line path in (A), (B), (C), and (D) in FIG. 12. It should be noted that when the laser emission tube D1 is connected to the output end of the first operational amplifier A1 through the first resistor R1, there is no end F in the circuit. When the resistance value of the third resistor R3 and the fourth resistor R4 is 0Ω, they can be regarded as wires. Therefore, the third resistor R3 and the fourth resistor R4 are not shown in (A) and (B) in FIG. 12.

When the input analog signal is a differential signal. The non-inverting input end of the first operational amplifier A1 is accessed to the input analog signal through the fifth resistor R5 and the inverting input end of the first operational amplifier A1 is accessed to the input analog signal through the sixth resistor R6. The non-inverting input end is connected to the preset reference voltage RER0 through the seventh resistor R7. At this time, the input analog signal may include a first input analog signal (Vin1) and a second input analog signal (Vin2) which are differential signals. The first operational amplifier A1 can perform operational amplification on the accessed first input analog signal (Vin1) and the second input analog signal (Vin2), and output them in the form of a single-ended signal (Vout) or a differential signal (Vout1 and Vout2), which can be specifically referred to (E) and (F) in FIG. 13 respectively. It should be noted that, when the first operational amplifier A1 outputs the differential signal (Vout1 and Vout2), the first operational amplifier A1 does not have a negative feedback path.

As shown in FIG. 14, in the second embodiment of the present application, the digital emission unit 20 includes a first low-pass filter unit 21, a first main control unit 22 and a digital emission module 23. The input end of the first low-pass filter unit 21 is the input end of the digital emission unit 20. The output end of the first low-pass filter unit 21 is connected to the controlled end of the digital emission module 23 through the first main control unit 22.

In an embodiment, the first main control unit 22 can be a microprocessor or main control chip such as MCU, DSP, FPGA, etc. that has an analog-to-digital conversion function, which is not limited here. The input end of the first low-pass filter unit 21 can be the input end of the digital emission unit 20. The first low-pass filter unit 21 is configured to low-pass filter the input analog signal accessed to the laser transmission circuit, and output the low-frequency component in the input analog signal to the analog input end of the first main control unit 22. After the driving signal converted into a digital electrical signal by the first main control unit 22, it is output to the controlled end of the digital emission module 23. So that the digital emission module 23 can transmit the corresponding digital signal according to the received driving signal, thereby realizing the transmission of digital signals. The digital signal can be a laser signal, an electromagnetic wave signal, an electrical signal or an optical signal, etc.

In an embodiment, the first main control unit 22 includes a first main controller 22B and a first analog-to-digital conversion module 22A. The first low-pass filter unit 21 is connected to the controlled end of the digital transmission module 23 through the first analog-to-digital conversion module 22A and the first main controller 22B.

In an embodiment, the first main controller 22B can output the driving signal of the analog electrical signal to the first analog-to-digital conversion module 22A according to the low-frequency component output by the first low-pass filter unit 21. After being converted into the driving signal of the digital electrical signal by the first analog-to-digital conversion module 22A, it is output to the digital emission module 23. Thus, the driving of the digital emission module 23 is realized. In short, it can be regarded as using the first analog-to-digital conversion module 22A to realize the analog-to-digital conversion function of the first main controller 22B. Since the digital electrical signal is configured to drive the digital emission module 23 to work, the working condition of the digital emission module 23 can be effectively prevented from being affected by the laser diode and the transmission environment. And then the digital signal transmission is affected, which is conducive to improving the stability of the digital signal process. In addition, it is relatively easy for the first main control unit 22 or the first analog-to-digital conversion module 22A to achieve high precision in practical applications. Therefore, it is also conducive to reducing the difficulty of high-precision realization of standard low-frequency components.

As shown in FIG. 14, in the second embodiment of the present application, the receiving unit 30 includes: an analog receiving unit 31, a digital receiving unit 32, and a signal processing unit 33.

The analog receiving unit 31 is configured to receive the analog laser signal and output an analog electrical signal.

The digital receiving unit 32 is configured to receive the digital signals and output the digital electrical signals.

A first input end of the signal processing unit 33 is connected to the output end of the analog receiving unit 31 and a second input end of the signal processing unit 33 is connected to the output end of the digital receiving unit 32. The signal processing unit 33 is configured to perform signal process on the accessed analog electrical signal and the digital electrical signal, and output a low-frequency correction signal to the feedback end of the analog receiving unit 31.

The analog receiving unit 31 is further used to correct the low-frequency operating point according to the received low-frequency correction signal, and output an analog electrical signal corresponding to the corrected low-frequency operating point.

In an embodiment, the analog receiving unit 31 can receive the analog laser signal through the laser receiving tube D2, generate a corresponding analog electrical signal according to the analog laser signal, and the analog electrical signal can be amplified and output as an output analog signal. It should be noted that the low-frequency offset of the low-frequency component in the output analog signal can be adjusted by changing the low-frequency operating point of the analog receiving unit 31. Specifically, when the output analog signal is affected by the laser diode and the transmission environment so that the voltage value corresponding to the low-frequency component is greater than the unaffected normal voltage value, the voltage value corresponding to the low-frequency component in the output analog signal can be restored to the normal voltage value by lowering the low-frequency operating point. When the output analog signal is affected by the laser diode and the transmission environment so that the voltage value corresponding to the low-frequency component is less than the unaffected normal voltage value, the voltage value corresponding to the low-frequency component in the output analog signal can be restored to the normal voltage value by raising the low-frequency operating point.

The digital receiving unit 32 can receive digital signals in the form of laser signals, electromagnetic wave signals, electrical signals or optical signals through a digital receiver, and can generate and output corresponding digital electrical signals according to the digital signals.

The first input end and the second input end of the signal processing unit 33 can be connected to the output end of the analog receiving unit 31 and the output end of the digital receiving unit 32 in a one-to-one correspondence, so as to respectively access the output analog signal and the digital electrical signal, and the abnormal low-frequency component in the output analog signal can be separated. It can be understood that the abnormal low-frequency component corresponds to the low-frequency component affected by the laser diode and the transmission environment, and the digital electrical signal corresponds to the standard low-frequency component not affected by the laser diode and the transmission environment. Therefore, the signal processing unit 33 can determine the degree of deviation of the abnormal low-frequency component according to the abnormal low-frequency component and the standard low-frequency component. And according to the determination result, the corresponding electrical signal can be output to increase or decrease the low-frequency operating point of the analog receiving unit 31 accordingly, so that the analog receiving unit 31 can re-perform the corresponding operation on the analog electrical signal accordingly and output it as a new output analog signal based on the low-frequency operating point after being raised or lowered. As such, by repeating the above process, the signal processing unit 33 can adjust the low-frequency operating point of the analog receiving unit 31 in real time, so that the analog receiving unit 31 can continuously output the output analog signal with the low-frequency component unaffected.

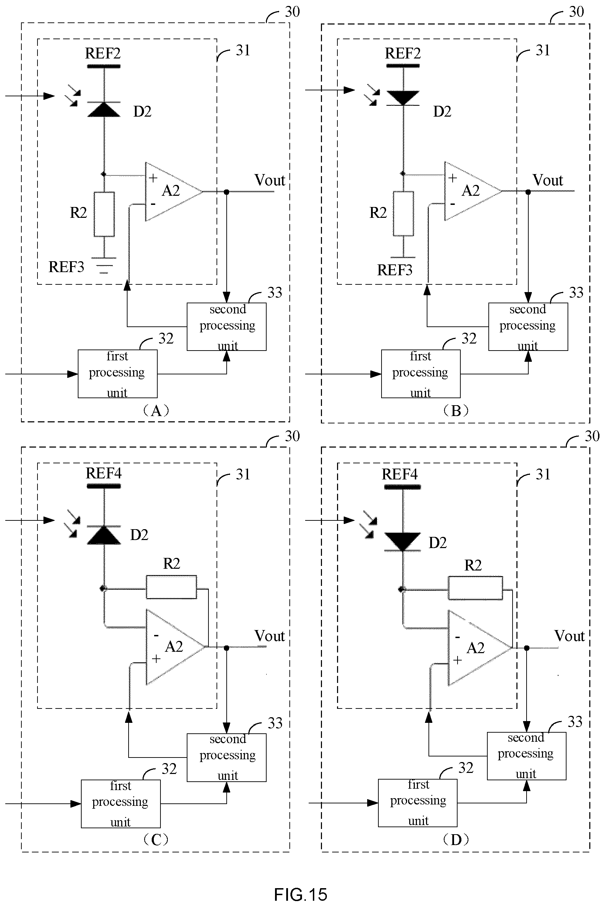

As shown in (A) and (B) in FIG. 15, in the second embodiment of the present application, the analog receiving unit 31 includes: a laser receiving tube D2, a second resistor R2, and a second amplifier circuit.

The first electrode of the laser receiving tube D2 is configured to access the second preset voltage. The second electrode of the laser receiving tube D2 is connected to the first input end of the second amplifier circuit. The second electrode of the laser receiving tube D2 is further connected to the third preset voltage through the second resistor R2. The second input end of the second amplifier circuit is the feedback end of the analog receiving unit 31. The output end of the second amplifier circuit is the output end of the analog receiving unit 31.

In an embodiment, the second amplifier circuit can be implemented by an operational amplifier or an operational amplifier chip. In an embodiment, it can be implemented by an amplifier circuit constructed by discrete devices such as triodes and resistors, which is not limited here. The working principle of the analog receiving unit 31 is explained in detail by taking the implementation of the second amplifier circuit by an operational amplifier (hereinafter referred to as the second operational amplifier A2) as an example. The non-inverting input end, the inverting input end and the output end of the second operational amplifier A1 can be the first input end, the inverting input end and the output end of the second amplifier circuit, respectively.

The laser receiving tube D2 has an anode and a cathode. When the first electrode is an anode and the second electrode is a cathode, the second preset voltage RER2 is less than the third preset voltage RER3. The laser receiving tube D2 generates a corresponding induced current according to the received analog laser signal. The current flows to the laser receiving tube D2 through the second resistor R2. When the first electrode is a cathode and the second electrode is an anode, the second preset voltage RER2 is greater than the third preset voltage RER3. The laser receiving tube D2 generates a corresponding induced current according to the received analog laser signal, which flows to the third preset voltage RER3 through the second resistor R2. The voltage signal formed at the connection between the laser receiving tube D2 and the second resistor R2 is amplified by the second operational amplifier A2 and output as an output analog signal. It can be understood that, in an embodiment, the low-frequency operating point of the analog receiving unit 31 is the low-frequency operating point of the second operational amplifier A2, and is corrected by the low-frequency correction signal accessed to its inverting end.

As shown in (C) and (D) in FIG. 15, in the second embodiment of the present application, the analog receiving unit 31 includes: a laser receiving tube D2, a second resistor R2 and a second amplifier circuit.

The first electrode of the laser receiving tube D2 is configured to access the fourth preset voltage. The second electrode of the laser receiving tube D2 is connected to the second input end of the second amplifier circuit. The second electrode of the laser receiving tube D2 is further connected to the output end of the second amplifier circuit through the second resistor R2. The first input end of the second amplifier circuit is the feedback end of the analog receiving unit 31. The output end of the second amplifier circuit is the output end of the analog receiving unit 31.

When the first electrode of the laser receiving tube D2 is an anode and the second electrode is a cathode, the laser receiving tube D2 generates a corresponding induced current according to the received analog laser signal. The current flows from the output end of the second operational amplifier A2 through the second resistor R2 through the laser receiving tube D2. When the first electrode of the laser receiving tube D2 is a cathode and the second electrode is an anode, the laser receiving tube D2 generates a corresponding induced current according to the received analog laser signal and flows into the output end of the second operational amplifier A2 through the second resistor R2. It can be understood that, in an embodiment, the low-frequency operating point of the analog receiving unit 31 is the low-frequency operating point of the second operational amplifier A2, and is corrected by the low-frequency correction signal accessed to its non-inverting end.

It should be noted that the first preset voltage REF1, the second preset voltage RER2, the third preset voltage RER3, and the fourth preset voltage RER4 recorded in this specification can be obtained by outputting the power management circuit in the device. And the voltage values of the four preset voltages can be the same or different, which is not limited here. In an embodiment, the first preset voltage REF1, the second preset voltage RER2, the third preset voltage RER3, and the fourth preset voltage RER4 can be implemented using a ground voltage.

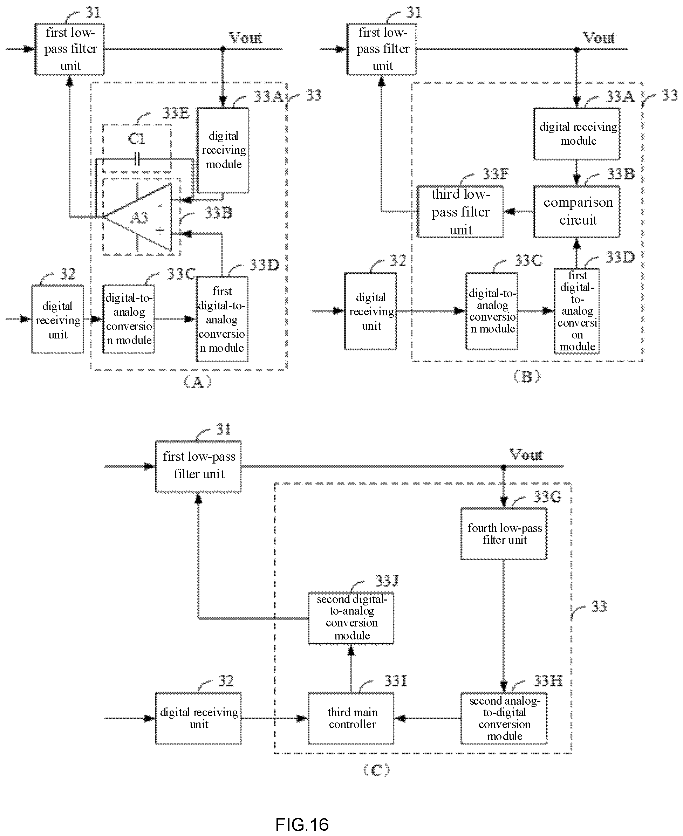

As shown in FIG. 16 (A), according to an embodiment of the present application, the signal processing unit 33 includes: a second low-pass filter unit 33A, a second main control unit and a comparison circuit 33B.

The input end of the second low-pass filter unit 33A is the first input end of the signal processing unit 33. The output end of the second low-pass filter unit is connected to the first input end of the comparison circuit 33B. The input end of the second main control unit is the second input end of the signal processing unit 33. The output end of the second main control unit is connected to the second input end of the comparison circuit 33B. The output end of the comparison circuit 33B is connected to the feedback end of the analog receiving unit 31.

The second low-pass filter unit 33A is configured to perform low-pass filtering on the output analog signal, so as to output the abnormal low-frequency component in the output analog signal to the first input end of the comparison circuit 33B. The second main control unit can be a main controller or a main control chip with an analog-to-digital conversion function. The main controller can be a microprocessor such as MCU, DSP, FPGA, etc. The second main control unit can perform signal processing and digital-to-analog conversion on the digital electrical signal output by the digital receiving unit 32 to an analog electrical signal representing a standard low-frequency component, and output to the second input end of the comparison circuit 33B. The comparison circuit 33B can compare and process the analog electrical signals connected to the first input end and the second input end respectively to obtain the low-frequency offset of the low-frequency component in the output analog signal, and can output the corresponding electrical signal (i.e., the low-frequency correction signal) to the feedback end of the analog receiving unit 31, thereby realizing the correction of the low-frequency operating point of the analog receiving unit 31.

In an embodiment, the comparison circuit 33B can be implemented by an amplifier circuit or a dedicated comparison chip; or, it can further be implemented by a comparison circuit constructed by a switch device and a discrete device. The specific implementation of the amplifier circuit (hereinafter referred to as the third amplifier circuit) can refer to the first amplifier circuit and the second amplifier circuit mentioned above, which will not be repeated herein. The working principle of the analog receiving unit 31 is explained in detail by taking the implementation of the third amplifier circuit by an operational amplifier (hereinafter referred to as the third operational amplifier A3) as an example. The non-inverting input end of the third operational amplifier A3 can be the non-inverting input end of the first amplifier circuit, the inverting input end of the third operational amplifier A3 can be the inverting input end of the first amplifier circuit and the output end of the third operational amplifier A3 can be the output end of the first amplifier circuit.

Any one of the non-inverting input end and the inverting input end of the third operational amplifier A3 can be the first input end of the comparison circuit 33B. The other can be the second input end. In the second embodiment, a capacitor circuit 33E is also connected between the first input end and the output end of the comparison circuit 33B. The capacitor circuit 33E may include at least one capacitor C to increase the working stability of the third operational amplifier A3.

In an embodiment, as shown in FIG. 16 (B), a low-pass filter unit may be connected between the output end of the comparison circuit 33B and the feedback end of the analog receiving unit 31, that is, the third low-pass filter unit 33F. The low-frequency correction signal output by the comparison circuit 33B is low-pass filtered and then output to the feedback end of the analog receiving unit 31 to ensure that there are no intermediate-frequency component and high-frequency component in the low-frequency correction signal received by the feedback end of the analog receiving unit 31, which is conducive to improving the stability of the low-frequency operating point correction of the analog receiving unit 31.

In an embodiment, the second main control unit includes: a second main controller 33C and a first digital-to-analog conversion module 33D. The input end of the second main controller 33C is the input end of the second main control unit. The output end of the second main controller 33C is connected to the input end of the first digital-to-analog conversion module 33D. The output end of the first digital-to-analog conversion module 33D is the output end of the second main control unit.

In an embodiment, the second main controller 33C can process the digital electrical signal output by the digital receiving unit 32 and output it to the first digital-to-analog conversion module 33D. After being converted by the first digital-to-analog conversion module 33D into an analog electrical signal, it is output to the signal processing unit 33. In short, it can be regarded as using the first digitalto-analog conversion module 33D to realize the analog-to-digital conversion function of the second main controller 33C.

As shown in FIG. 16 (C), in the second embodiment of the present application, the signal processing unit 33 includes: a fourth low-pass filter unit 33G and a third main control unit.

The input end of the fourth low-pass filter unit 33G is the first input end of the signal processing unit 33. The output end of the fourth low-pass filter unit 33G is connected to the second input end of the third main control unit. The second input end of the third main control unit is the second input end of the signal processing unit 33. The output end of the third main control unit is the output end of the analog receiving unit 31.

In an embodiment, the fourth low-pass filter unit 33G is configured to perform low-pass filtering on the output analog signal to output the abnormal low-frequency component in the output analog signal to the third main control unit. The third main control unit can be a main controller or a main control chip that has analog-to-digital conversion function and digital-to-analog conversion function. The main controller can be a microprocessor such as MCU, DSP, FPGA, etc. The third main control unit can directly access the digital electrical signal output by the digital receiving unit 32, and after the abnormal low-frequency component is converted into a digital signal through analog-to-digital conversion, the pre-integrated hardware circuit and software program or algorithm can be run to operate the two digital electrical signals to determine the low-frequency offset of the low-frequency component in the output analog signal. The third main control unit can further directly output the low-frequency correction signal of the analog electrical signal to the feedback end of the analog receiving unit 31 according to the determination result, thereby realizing the low-frequency operating point correction of the analog receiving unit 31.

In an embodiment, the third main control unit includes: a second analog-to-digital conversion module 33H, a third main controller 331, and a second digital-to-analog conversion module 33J.

The third main controller 33I is connected to the output end of the digital receiving unit 32. The third main controller 331 is further connected to the output end of the analog receiving unit 31 through the second analog-to-digital conversion module 33H. The third main controller 331 is further connected to the feedback end of the analog receiving unit 31 through the second digital-to-analog conversion module 33J.

In an embodiment, the third main control unit may include: a second analog-to-digital conversion module 33H, a third main controller 331 and a second digital-to-analog conversion module 33J. The third main controller 331 may be directly connected to the output end of the digital receiving unit 32 to access the digital electrical signal output by the digital receiver. The second analog-to-digital conversion module 33H may be connected to the output end of the fourth low-pass filter unit 33G to convert the abnormal low-frequency component output by the fourth low-pass filter unit 33G into a digital signal and then output it to the third main controller 331. The third main controller 331 may perform corresponding operations on the two digital electrical signals to determine the low-frequency offset of the low-frequency component in the output analog signal, and the low-frequency correction signal of the digital electrical signal may be output to the second digital-to-analog conversion module 33J. After being converted into an analog electrical signal by the second digital-to-analog conversion module 33J, it is output to the feedback end of the analog receiving unit 31. In short, it can be regarded as using the second analog-to-digital conversion module 33H and the second digital-to-analog conversion module 33J to respectively realize the analog-to-digital conversion function and the digital-to-analog conversion function of the second main controller 33C. In addition, the second main control unit, the third main control unit, the first digital-to-analog conversion module 33D, the second digital-to-analog conversion module 33J and the second analog-to-digital conversion module 33H are less difficult to achieve high precision in actual applications, which is also conducive to reducing the difficulty of achieving high precision of low-frequency operating point correction.

As shown in FIGS. 14 to 16, according to the second embodiment of the present application, the digital emission module 23 is a laser transmitter, and the digital receiving unit 32 is a laser receiver.

The laser transmitter can output a digital signal in the form of laser to the laser receiver under the drive of a digital electrical signal, so that the laser receiver can generate and output a corresponding digital electrical signal according to the received digital signal in the form of laser, thereby realizing laser transmission of low-frequency components. It should be noted that, since is it is driven by the digital electrical signal, the digital laser signal output by the laser transmitter will not be affected by the laser diode and the transmission environment, so that the laser receiver can restore the output without offset and represent the digital electrical signal of the standard low-frequency component.

In an embodiment, the digital emission module 23 is a wireless transmitting circuit, and the digital receiving unit 32 is a wireless receiving circuit.

The wireless transmitting circuit and the wireless receiving unit may be near-field communication circuits such as infrared communication circuits, Bluetooth communication circuits, ultra-wideband communication circuits, ZigBee communication circuits, and radio frequency identification (RFID) communication circuits. Or they may also be far-field communication circuits such as 3G communication circuits, 4G communication circuits, 5G communication circuits, Wi-Fi communication circuits, WiGig communication circuits, and wireless broadband Internet communication circuits, which is not limited here. The wireless transmitting circuit may be driven by a digital electrical signal to output a digital signal in the form of infrared, electromagnetic waves, etc., to the wireless receiving circuit, so that the wireless receiving unit can generate and output a corresponding digital electrical signal according to the received digital signal in the form of infrared, electromagnetic waves, etc., thereby realizing wireless communication transmission of low-frequency components.

In an embodiment, the digital emission module 23 is an opto-coupler unit. The digital receiving unit 32 is a main controller.

The opto-coupler unit can access the digital electrical signal output by the first analog-to-digital conversion module 22A through the primary side, and can generate and output a corresponding digital electrical signal through the secondary side under the drive of the digital electrical signal, thereby realizing optical communication transmission of the low-frequency component.

In an embodiment, the digital emission module 23 is a main controller, and the digital receiving unit 32 is an opto-coupler unit.

The main controller can access the digital electrical signal output by the first analog-to-digital conversion module 22A, and can output the digital electrical signal after signal processing, so as to be received and identified by the primary side of the opto-coupler unit in the receiving unit 30, thereby realizing the communication transmission of the low-frequency component.

### Third embodiment

The present application further provides a laser transmission component. The laser transmission component includes a laser transmission circuit. The specific structure of the laser transmission circuit refers to the above-mentioned embodiments. Since the laser transmission component adopts all the technical solutions of all the above-mentioned embodiments, it has at least all the beneficial effects brought by the technical solutions of the above-mentioned embodiments. No further description will be given here.

The laser transmission component may include an emission component and a receiving component. When the laser transmission component adopts the laser transmission circuit of the first embodiment, the analog emission unit 10 and the digital emission unit 20 may be provided in the emission component, and the receiving unit 30 may be provided in the receiving component. Thus, the laser transmission of the analog signal between the emission component and the receiving component can be realized. When the laser transmission component adopts the laser transmission circuit of the second embodiment, the analog emission unit 10 and the digital receiving feedback path in the digital feedback path 30 may be provided in the emission component, and the analog receiving unit 20 and the digital filtering transmitting path in the digital feedback path 30 may be provided in the receiving component. Thus, the laser transmission of the analog signal between the emission component and the receiving component can be realized.

### Fourth embodiment

The present application further provides an electronic measuring instrument. The electronic measuring instrument includes a laser transmission circuit or a laser transmission component. The specific structure of the laser transmission circuit refers to the first embodiment and the second embodiment. The specific structure of the laser transmission component refers to the above-mentioned third embodiment. Since the electronic measuring instrument adopts all the technical solutions of all the above-mentioned embodiments, it has at least all the beneficial effects brought by the technical solutions of the above-mentioned embodiments, which will not be repeated herein.

The electronic measuring instruments may include but are not limited to: digital oscilloscopes, spectrum and network analyzers, signal and waveform generators.

The electronic measuring instrument may include at least a measuring component and a device body. The emission component may be provided in the measuring component. The receiving component may be provided in the device body. Thus, the laser transmission of analog signals between the measuring component and the device body can be realized. Of course, the measuring component may also be entirely provided in the device body to realize the laser transmission of analog signals between the functional components inside the device body.

In an embodiment, the electronic measuring instrument is an oscilloscope.

In an embodiment, the device body can be an oscilloscope body. The measuring component can include at least two probes, and the oscilloscope can further include a signal modulation box connected to each probe and the device body respectively. An emission component can be provided in any probe. The signal modulation box can be provided with at least two receiving components and one emission component. Each receiving component can be provided corresponding to a probe. The emission component can be provided corresponding to the device body. The signal modulation box can receive the analog signal transmitted by the laser of each probe through each receiving component, and after signal processing of each accessed analog signal, it can be transmitted to the device body through the emission component for the device body to receive and display. All components can further be provided in the oscilloscope, and complete the transmission process in the oscilloscope.

The following will be combined with the drawings in the embodiments of the present application to clearly and completely describe the technical solutions in the embodiments of the present application. Obviously, the described embodiments are only part of the embodiments of the present application, not all of the embodiments. All other embodiments obtained by those skilled in the art without creative work based on the embodiments in the present application belong to the scope of protection of the present application.

## Claims

1. A laser transmission circuit, **characterized by** comprising:
an analog emission unit;
an analog receiving unit; and
a digital feedback path, wherein:
an input end of the analog emission unit is configured to access an input analog signal, convert the input analog signal into an analog laser signal, and emit the analog laser signal;
the analog receiving unit is configured to receive the analog laser signal emitted by the analog emission unit, and convert the analog laser signal into an analog electrical signal as an output signal of the laser transmission circuit;
an input end of the digital feedback path is connected to an output end of the analog receiving unit, an output end of the digital feedback path is connected to a feedback input end of the analog emission unit;
the digital feedback path is configured to access the analog electrical signal output by the analog receiving unit, convert the analog electrical signal into a digital signal, and transmit the digital signal; and
the digital feedback path is further configured to convert the transmitted digital signal into a low-frequency analog signal, and output the low-frequency analog signal to a feedback input end of the analog emission unit.

2. The laser transmission circuit according to claim 1, wherein:
the analog emission unit comprises a drive feedback module and a laser emission module;
an input end of the drive feedback module is connected to the input end of the analog emission unit, and a first feedback input end of the drive feedback module is connected to the output end of the digital feedback path;
a first end of the laser emission module is connected to an output end of the drive feedback module, and a second end of the laser emission module is configured to access a first preset reference voltage; or
the first end of the laser emission module is connected to a positive output end of the drive feedback module, and the second end of the laser emission module is connected to a negative output end of the drive feedback module.

3. The laser transmission circuit according to claim 2, wherein:
the laser emission module comprises a laser emission tube and a first resistor;
one end of the first resistor is connected to the first end of the laser emission module, and another end of the first resistor is connected to the second end of the laser emission module through the laser emission tube; or
the first end of the laser emission tube is connected to the first end of the laser emission module, and the other end of the laser emission tube is connected to the second end of the laser emission module through the first resistor.

4. The laser transmission circuit according to claim 3, wherein:
a connection point between the laser emission tube and the first resistor is end F; and
the drive feedback module comprises a second feedback input end, and the second feedback input end of the drive feedback module is connected to the end F or the output end of the drive feedback module.

5. The laser transmission circuit according to claim 4, wherein:
the drive feedback module comprises a first amplifier circuit, a high-frequency feedback path, and a low-frequency feedback path;
the first input end of the first amplifier circuit is connected to an input end of the drive feedback module, the output end of the first amplifier circuit is connected to the output end of the drive feedback module;
a first input end of the low-frequency feedback path is connected to the first feedback input end of the drive feedback module;
an input end of the high-frequency feedback path is connected to the second feedback input end of the drive feedback module; and
an output end of the high-frequency feedback path is connected to a second input end of the first amplifier circuit, and an output end of the low-frequency feedback path is connected to the second input end of the first amplifier circuit.

6. The laser transmission circuit according to claim 5, wherein:
the first amplifier circuit comprises a first operational amplifier;
one first input end of the first amplifier circuit is provided, a non-inverting input end or an inverting input end of the first operational amplifier is the first input end of the first amplifier circuit, the inverting input end of the first operational amplifier is the second input end of the first amplifier circuit, and the non-inverting input end or the inverting input end of the first operational amplifier is accessed to the input analog signal of a single-ended signal through a second resistor; or
two first input ends of the first amplifier circuit are provided, the non-inverting input end and the inverting input end of the first operational amplifier are respectively the two first input ends of the first amplifier circuit, the inverting input end of the first operational amplifier is the second input end of the first amplifier circuit, the non-inverting input end is accessed to an input analog signal of a differential signal respectively through a third resistor, the inverting input end of the first operational amplifier is accessed to the input analog signal of the differential signal through a fourth resistor, and the non-inverting input end of the first operational amplifier is further accessed to a second preset reference voltage through a fifth resistor.

7. The laser transmission circuit according to claim 5, wherein the high-frequency feedback path comprises a first capacitor, one end of the first capacitor is connected to the input end of the high-frequency feedback path, and another end of the first capacitor is connected to the output end of the high-frequency feedback path.

8. The laser transmission circuit according to claim 5, wherein:
the low-frequency feedback path is further provided with a second input end, and the second input end of the low-frequency feedback path is connected to the second feedback input end of the drive feedback module;
the low-frequency feedback path comprises a two-to-one switch and a sixth resistor; and
a first input end of the two-to-one switch is connected to a first input end of the low-frequency feedback path to access the low-frequency analog signal; a second input end of the two-to-one switch is connected to a second input end of the low-frequency feedback path, one end of the sixth resistor is connected to an output end of the two-to-one-one switch, and the another end of the sixth resistor is connected to the output end of the low-frequency feedback path.

9. The laser transmission circuit according to claim 1, wherein:
the analog receiving unit comprises a second amplifier circuit, a laser receiving tube, and a seventh resistor, and an output end of the second amplifier circuit is connected to the output end of the analog receiving unit;
a first end of the laser receiving tube is configured to access a third preset reference voltage, a second end of the laser receiving tube is connected to one end of the seventh resistor and a first input end of the second amplifier circuit respectively, another end of the seventh resistor is configured to access a fourth preset reference voltage; or
the first end of the laser receiving tube is configured to access a third preset reference voltage, the second end of the laser receiving tube is connected to one end of the seventh resistor and a first input end of the second amplifier circuit respectively, and another end of the seventh resistor is connected to the output end of the second amplifier circuit, and a second input end of the second amplifier circuit is configured to access the fourth preset reference voltage; or
the first end of the laser receiving tube is configured to access the third preset reference voltage, the second end of the laser receiving tube is connected to one end of the seventh resistor, and another end of the seventh resistor is configured to access the fourth preset reference voltage, the first input end of the second amplifier circuit is connected to one end of the seventh resistor, and the second input end of the second amplifier circuit is connected to another end of the seventh resistor.

10. The laser transmission circuit according to claim 1, wherein:
the digital feedback path comprises a first low-pass filter unit, a first processing unit, and a second processing unit;
an input end of the first low-pass filter unit is connected to the input end of the digital feedback path, the first low-pass filter unit is configured to output the analog electrical signal after low-pass filtering;
an input end of the first processing unit is connected to an output end of the first low-pass filter unit, the first processing unit is configured to convert the low-pass filtered analog electrical signal into a digital signal and output the digital signal; and
an output end of the second processing unit is connected to an output end of the digital feedback path, the second processing unit is configured to receive the digital signal emitted by the first processing unit, convert the digital signal into a low-frequency analog signal, and output the low-frequency analog signal to the output end of the digital feedback path.

11. The laser transmission circuit according to claim 10, wherein:
the first processing unit comprises:
an analog-to-digital conversion module;
a first processor; and
a digital emission module,
the second processing unit comprises:
a digital receiving module;
a second processor; and
a digital-to-analog conversion module,
an input end of the analog-to-digital conversion module is connected to the input end of the first processing unit, an output end of the analog-to-digital conversion module is connected to an input end of the first processor, an output end of the first processor is connected to the input end of the digital emission module, and the digital emission module is configured to emit the digital signal; and
the digital receiving module is configured to receive the digital signal emitted by the digital emission module, an output end of the digital receiving module is connected to an input end of the second processor, an output end of the second processor is connected to an input end of the digital-to-analog conversion module, and an output end of the digital-to-analog conversion module is connected to the output end of the second processing unit.

12. The laser transmission circuit according to claim 11, wherein:
the digital emission module is a laser transmitting tube, and the digital receiving module is the laser receiving tube; or
the digital emission module is a wireless transmitting circuit, and the digital receiving module is a wireless receiving circuit; or
the digital emission module is an opto-coupler unit, and the digital receiving module is a main controller; or
the digital emission module is the main controller, and the digital receiving module is the opto-coupler unit.

13. The laser transmission circuit according to claim 10, wherein:
the digital feedback path further comprises a second low-pass filter unit, an input end of the second low-pass filter unit is connected to the output end of the second processing unit, an output end of the second low-pass filter unit is connected to the output end of the digital feedback path; and
the second low-pass filter unit is configured to low-pass filter and output the low-frequency analog signal output by the second processing unit to the analog emission unit.

14. A laser transmission circuit, **characterized by** comprising:
an analog emission unit;
a digital emission unit; and
a receiving unit, wherein:
an input end of the analog emission unit is configured to access an input analog signal of the laser transmission circuit, and emit an analog laser signal corresponding to the input analog signal;
an input end of the digital emission unit is configured to access the input analog signal of the laser transmission circuit, and emit a digital signal corresponding to a low-frequency component of the input analog signal;
the receiving unit is configured to receive the analog laser signal output by the analog emission unit and the digital signal output by the digital emission unit, and generate an analog electrical signal corresponding to the analog laser signal and a digital electrical signal corresponding to the digital signal; and
the receiving unit is further configured to correct the generated analog electrical signal according to the generated digital electrical signal, and output the corrected analog electrical signal.

15. The laser transmission circuit according to claim 14, wherein:
the analog emission unit comprises a drive module and a laser emission module;
an input end of the drive module is connected to an input end of the analog emission unit;
a first end of the laser emission module is connected to an output end of the drive module, and a second end of the laser emission module is configured to access a first preset voltage; or
the first end of the laser emission module is connected to a positive output end of the drive module, and the second end of the laser emission module is connected to a negative output end of the drive module to access a differential signal output by the drive module.

16. The laser transmission circuit according to claim 15, wherein:
the laser emission module comprises a laser emission tube and a first resistor;
one end of the first resistor is connected to the first end of the laser emission module, and another end of the first resistor is connected to the second end of the laser emission module through the laser emission tube; or
the first end of the laser emission tube is connected to the first end of the laser emission module, and another end of the laser emission tube is connected to the second end of the laser emission module through the first resistor.

17. The laser transmission circuit according to claim 16, wherein:
in response to that the first end of the laser emission tube is connected to the first end of the laser emission module and another end of the laser emission tube is connected to the second end of the laser emission module through the first resistor, a connection point between the laser emission tube and the first resistor is an end F; the drive module comprises a first amplifier circuit, and the first amplifier circuit is provided with a non-inverting input end and an inverting input end;
the input analog signal is a single-ended signal, the non-inverting input end or the inverting input end of the first amplifier circuit is connected to the input analog signal through a third resistor, a second input end of the first amplifier circuit is further connected to an output end of the first amplifier circuit or the end F through a fourth resistor; or
the input analog signal is a differential signal, the non-inverting input end of the first amplifier circuit is accessed to the input analog signal through a fifth resistor, the inverting input end of the first amplifier circuit is accessed to the input analog signal through a sixth resistor, and the non-inverting input end is accessed to a reference voltage through a seventh resistor.

18. The laser transmission circuit according to claim 14, wherein:
the digital emission unit comprises a first low-pass filter unit, a first main control unit and a digital emission module; and
an input end of the first low-pass filter unit is the input end of the digital emission unit, and an output end of the first low-pass filter unit is connected to a controlled end of the digital emission module through the first main control unit.

19. The laser transmission circuit according to claim 18, wherein the first main control unit comprises a first main controller and a first analog-to-digital conversion module, and the first low-pass filter unit is connected to the controlled end of the digital emission module through the first main controller and the first analog-to-digital conversion module.

20. The laser transmission circuit according to claim 14, wherein:
the receiving unit comprises:
an analog receiving unit configured to receive the analog laser signal and output the analog electrical signal;
a digital receiving unit configured to receive the digital signal and output the digital electrical signal; and
a signal processing unit,
a first input end of the signal processing unit is connected to an output end of the analog receiving unit and a second input end of the signal processing unit is connected to an output end of the digital receiving unit, the signal processing unit is configured to perform signal process on the accessed analog electrical signal and the digital electrical signal, and output a low-frequency correction signal to a feedback end of the analog receiving unit;
the analog receiving unit is further configured to correct a low-frequency operating point according to the received low-frequency correction signal, and output an analog electrical signal corresponding to the corrected low-frequency operating point.

21. The laser transmission circuit according to claim 20, wherein:
the analog receiving unit comprises a laser receiving tube, a second resistor, and a second amplifier circuit,
a first electrode of the laser receiving tube is configured to access a second preset voltage, a second electrode of the laser receiving tube is connected to a first input end of the second amplifier circuit, the second electrode of the laser receiving tube the electrode is further connected to a third preset voltage through the second resistor, a second input end of the second amplifier circuit is a feedback end of the analog receiving unit, and an output end of the second amplifier circuit is the output end of the analog receiving unit; or
the first electrode of the laser receiving tube is configured to access a fourth preset voltage, the second electrode of the laser receiving tube is connected to a second input end of the second amplifier circuit, the second electrode of the laser receiving tube is further connected to the output end of the second amplifier circuit through the second resistor, the first input end of the second amplifier circuit is the feedback end of the analog receiving unit, and the output end of the second amplifier circuit is the output end of the analog receiving unit.

22. The laser transmission circuit according to claim 20, wherein:
the signal processing unit comprises a second low-pass filter unit, a second main control unit, and a comparison circuit; and
an input end of the second low-pass filter unit is the first input end of the signal processing unit, the output end of the second low-pass filter unit is connected to a first input end of the comparison circuit, and an input end of the second main control unit is the second input end of the signal processing unit, an output end of the second main control unit is connected to a second input end of the comparison circuit, and an output end of the comparison circuit is connected to the feedback end of the analog receiving unit.

23. The laser transmission circuit according to claim 22, wherein:
the comparison circuit comprises a third amplifier circuit, a non-inverting input end of the third amplifier circuit is the first input end of the comparison circuit, and a second input end of the third amplifier circuit is the second input end of the comparison circuit; or, the second input end of the third amplifier circuit is the first input end of the comparison circuit, and the non-inverting end of the third amplifier circuit is the second input end of the third amplifier circuit; and
the signal processing unit further comprises a capacitor circuit connected between the first input end and the output end of the comparison circuit.

24. The laser transmission circuit according to claim 22, wherein the signal processing unit comprises a third low-pass filter unit, and the output end of the comparison circuit is connected to the feedback end of the analog receiving unit through the third low-pass filter unit.

25. The laser transmission circuit according to claim 22, wherein:
the second main control unit comprises a second main controller and a first digital-to-analog conversion module; and
an input end of the second main controller is the input end of the second main control unit, an output end of the second main controller is connected to an input end of the digital-to-analog conversion module, and an output end of the first digital-to-analog conversion module is the output end of the second main control unit.

26. The laser transmission circuit according to claim 20, wherein:
the signal processing unit comprises a fourth low-pass filter unit and a third main control unit; and
an input end of the fourth low-pass filter unit is the first input end of the signal processing unit, and an output end of the fourth low-pass filter unit is connected to a first input end of the third main control unit, a second input end of the third main control unit is a second input end of the signal processing unit, and an output end of the third main control unit is an output end of the signal processing unit.

27. The laser transmission circuit according to claim 26, wherein:
the third main control unit comprises a second analog-to-digital conversion module, a third main controller, and a second digital-to-analog conversion module; and
the third main controller is connected to the output end of the digital receiving unit, the third main controller is further connected to an output end of the fourth low-pass filter unit through the second analog-to-digital conversion module, and the third main controller is further connected to the feedback end of the analog receiving unit through the second digital-to-analog conversion module.

28. The laser transmission circuit according to claim 20, wherein:
the digital emission module is a laser transmitter, and the digital receiving unit is a laser receiver; or
the digital emission module is a wireless transmitting circuit, and the digital receiving unit is a wireless receiving circuit; or
the digital emission module is an opto-coupler unit, and the digital receiving unit is a main controller; or
the digital emission module is the main controller, and the digital receiving unit is the opto-coupler unit.

29. A laser transmission component, **characterized by** comprising the laser transmission circuit according to any one of claims 1 to 13; or, the laser transmission circuit according to any one of claims 14 to 28.

30. An electronic measuring instrument, **characterized by** comprising the laser transmission circuit according to any one of claims 1 to 13; or, the laser transmission circuit according to any one of claims 14 to 28; or, the laser transmission component according to claim 29.

31. The electronic measuring instrument according to claim 30, wherein the electronic measuring instrument is an oscilloscope.
